# EUROPEAN PATENT APPLICATION

(11) **EP 4 328 742 A1**
(43) Date of publication of application: **28.02.2024**
(21) Application number: 22794998.9
(22) Date of filing: 28.04.2022
(51) Int. Cl.: G06F 9/30

(54) **SIMULATION METHOD AND APPARATUS FOR VEHICLE SIMULATION SYSTEM, DEVICE AND STORAGE MEDIUM**

(30) Priority: 29.04.2021 CN 202110478140; 29.04.2021 CN 202110478478; 29.04.2021 CN 202110478476; 29.04.2021 CN 202110478840
(71) Applicant: Human Horizons (Shanghai) Cloud Computing Technology Co., Ltd., Shanghai 201100 (CN)
(72) Inventor: WANG, Qingping, Shanghai 201100 (CN); XU, Chao, Shanghai 201100 (CN)
(74) Representative: Meyer, Thorsten
(86) International application number: PCT/CN2022/089972
(87) International publication number: WO 2022/228528

(57) **Abstract**

The present invention, relating to the field of vehicle technologies, provides an emulation method, apparatus, device, and storage medium for a vehicle simulation system. The method includes: receiving, by the vehicle simulation system, an inside-and-outside-vehicle environmental parameter and a functional instruction set obtained through a user's operation on a vehicle control instruction block; integrating and converting, by the vehicle simulation system, the functional instruction set and the inside-and-outside-vehicle environmental parameter into an instruction execution sequence; rendering, by the vehicle simulation system, a preset vehicle model according to the instruction execution sequence to obtain a presentation effect image and/or a presentation animation of the preset vehicle model executing the functional instruction set under the inside-and-outside-vehicle environmental parameter. The emulation method, apparatus, device and storage medium for a vehicle simulation system provided by the present invention facilitate users in creating vehicle control instructions according to their personal preferences, and present the control effects of the vehicle control instructions, thus enhancing the user's driving experience.

## Description

### FIELD OF THE INVENTION

The present invention relates to the field of vehicle technologies, particularly to an emulation method, apparatus, device, and storage medium for a vehicle simulation system.

### BACKGROUND OF THE INVENTION

With the continuous improvement in the level of vehicle electrification, networking, and intelligence, configuration features such as vehicle-mounted video entertainment systems are becoming increasingly powerful, bringing people unlimited joy and enjoyment in their driving experiences. However, vehicle central control systems typically have a limited number of vehicle control instructions, which makes them unable to achieve coordinated control of vehicle equipment based on users' personal preferences, thus unable to meet the growing need for individualized vehicle control.

When users are dissatisfied with the limited number of vehicle control instructions provided by the existing vehicle control platform, they would propose self-created instructions tailored to their preferences that can achieve the intended effects. These instructions are then sent to the vehicle for execution via the cloud. However, regarding the verification operation for each self-created vehicle control instruction, whether the self-created vehicle control instruction meets expectations can only be determined through the actual operation of the vehicle. If it does not meet expectations, repeated adjustments and re-verification through the actual operations of the vehicle need to be made. This process consumes a significant amount of time and effort, impacting the user experience.

### SUMMARY OF THE INVENTION

The present invention provides an emulation method, apparatus, device and storage medium for a vehicle simulation system, aiming to address the technical issues in the prior art where vehicles cannot provide personalize vehicle controls for users. The present invention opens a platform for users to design vehicle control instructions, facilitating users in creating vehicle control instructions based on their personal preferences, and presents the control effects of the vehicle control instructions, thus enhancing the user's driving experience.

To address the above technical issue, in a first aspect, an embodiment of the present invention provides an emulation method for a vehicle simulation system, the method includes:
receiving, by the vehicle simulation system, an inside-and-outside-vehicle environmental parameter and a functional instruction set obtained through a user's operation on a vehicle control instruction block;
integrating and converting, by the vehicle simulation system, the functional instruction set and the inside-and-outside-vehicle environmental parameter into an instruction execution sequence;
rendering, by the vehicle simulation system, a preset vehicle model according to the instruction execution sequence to obtain a presentation effect image and/or a presentation animation of the preset vehicle model executing the functional instruction set under the inside-and-outside-vehicle environmental parameter.

As one of the preferred solutions, before the process of receiving, by the vehicle simulation system, an inside-and-outside-vehicle environmental parameter and a functional instruction set obtained through a user's operation on a vehicle control instruction block, the method further includes:
downloading, by the vehicle simulation system, a software package of the vehicle control instruction block based on OTA technology;
processing, by the vehicle simulation system, the software package of the vehicle control instruction block to obtain the vehicle control instruction block for the user to operate.

As one of the preferred solutions, the process of downloading, by the vehicle simulation system, a software package of the vehicle control instruction block based on OTA technology, specifically includes:
sending, by the vehicle simulation system, a download request for the software package of the vehicle control instruction block to a vehicle server;
receiving, by the vehicle simulation system, version options for the software package of the vehicle control instruction block sent by the vehicle server according to the download request;
sending, by the vehicle simulation system, version information of a target version selected from the version options by the user to the vehicle server;
receiving, by the vehicle simulation system, a download address of a target software package of the vehicle control instruction block sent by the vehicle server according to the version information of the target version;
downloading, by the vehicle simulation system, the target software package of the vehicle control instruction block according to the download address based on OTA technology.

As one of the preferred solutions, the download request includes a device identifier of the vehicle, current version information of the software package of the vehicle control instruction block, and version authentication information corresponding to the current version information;
wherein, the device identifier, the current version information, and the version authentication information corresponding to the current version information are used for the vehicle server to authenticate the download request.

As one of the preferred solutions, after the process of downloading, by the vehicle simulation system, the target software package of the vehicle control instruction block according to the download address, the method further includes:
loading, by the vehicle simulation system, the target software package of the vehicle control instruction block, updating the current version information to the version information of the target software package of the vehicle control instruction block, and updating the version authentication information corresponding to the current version information to the version authentication information corresponding to the target software package of the vehicle control instruction block.

As one of the preferred solutions, in a case where a plurality of the download addresses are provided, the process of downloading, by the vehicle simulation system, the target software package of the vehicle control instruction block according to the download address, specifically includes:
receiving, by the vehicle simulation system, a download speed of the target software package of the vehicle control instruction block at a current selected download address;
switching to a different download address to download the target software package of the vehicle control instruction block when there is an anomaly in the download speed.

As one of the preferred solutions, the process of downloading, by the vehicle simulation system, the target software package of the vehicle control instruction block according to the download address, specifically includes:
downloading, by the vehicle simulation system, all program blocks of the target software package of the vehicle control instruction block according to the download address and a pre-set download order of the program blocks of the target software package of the vehicle control instruction block.

As one of the preferred solutions, the process of downloading, by the vehicle simulation system, all program blocks of the target software package of the vehicle control instruction block according to the download address and a pre-set download order of the program blocks of the target software package of the vehicle control instruction block, specifically includes:
downloading, by the vehicle simulation system, the program block of the target software package of the vehicle control instruction block according to the download address and the pre-set download order of the program blocks of the target software package of the vehicle control instruction block and receiving the download speed of the program block;
choosing a next program block in the download order for downloading when there is an anomaly in the download speed until all the program blocks of the target software package of the vehicle control instruction block are downloaded.

As one of the preferred solutions, the process of downloading, by the vehicle simulation system, the target software package of the vehicle control instruction block according to the download address, specifically includes:
verifying, by the vehicle simulation system, validity of the download address;
downloading the target software package of the vehicle control instruction block when the download address is valid.

As one of the preferred solutions, the target software package of the vehicle control instruction block is encrypted, in this case after the process of downloading, by the vehicle simulation system, the target software package of the vehicle control instruction block, the method further includes:
decrypting, by the vehicle simulation system, the target software package of the vehicle control instruction block to obtain a decrypted target software package of the vehicle control instruction block;
verifying, by the vehicle simulation system, validity of the decrypted target software package of the vehicle control instruction block;
loading the decrypted target software package of the vehicle control instruction block when the decrypted target software package of the vehicle control instruction block is valid.

As one of the preferred solutions, the method further includes:
receiving, by the vehicle server, the user's operation information for the vehicle simulation system;
storing, by the vehicle server, the operation information.

As one of the preferred solutions, the process of storing, by the vehicle server, the operation information, specifically includes:
checking, by the vehicle server, whether there is an anomaly in the operation information;
storing, by the vehicle server, the operation information on a disk as an abnormal operation information if there is an anomaly in the operation information;
storing, by the vehicle server, the operation information on the disk as a normal operation information if there is no anomaly in the operation information and recording a storing time.

As one of the preferred solutions, after the process of storing, by the vehicle server, the operation information on a disk as an abnormal operation information, the method further includes:
checking, by the vehicle server, an anomaly level of the abnormal operation information;
sending, by the vehicle server, the abnormal operation information to an abnormal operation information processing terminal when the anomaly level meets a preset anomaly level condition.

As one of the preferred solutions, the process of checking, by the vehicle server, whether there is an anomaly in the operation information, specifically includes:
checking, by the vehicle server, whether the vehicle control instruction block is a registered valid vehicle control instruction block;
determining, by the vehicle server, that there is an anomaly in the operation information if the vehicle control instruction block is not a valid vehicle control instruction block;
checking, by the vehicle server, whether a version of the vehicle control instruction block is the current version if the vehicle control instruction block is a valid vehicle control instruction block;
determining, by the vehicle server, that there is an anomaly in the operation information if the version is not the current version;
checking, by the vehicle server, whether a parameter configured in the vehicle control instruction block exceeds a parameter threshold range if the version is the current version;
determining, by the vehicle server, that there is an anomaly in the operation information if the parameter exceeds the parameter threshold range;
determining, by the vehicle server, that there is no anomaly in the operation information if the parameter doesn't exceed the parameter threshold range;

As one of the preferred solutions, the process of storing, by the vehicle server, the operation information on the disk as a normal operation information if there is no anomaly in the operation information and recording a storing time, specifically includes:
compressing, by the vehicle server, the operation information through a preset compression algorithm if there is no anomaly in the operation information;
storing, by the vehicle server, the compressed operation information on the disk as a normal operation information and recording the storing time.

As one of the preferred solutions, the method further includes:
checking, by the vehicle server, whether a usage rate of the disk is over a usage rate threshold;
deleting, by the vehicle server, the normal operation information according to the storing time if the usage rate is greater than the usage rate threshold.

As one of the preferred solutions, the anomaly level dynamically increases and decreases according to a frequency of occurrence of a type of the abnormal operation information's type.

As one of the preferred solutions, the process of sending, by the vehicle server, the abnormal operation information to an abnormal operation information processing terminal, specifically includes:
encrypting, by the vehicle server, the abnormal operation information and setting a permission level, and then sending the abnormal operation information to the abnormal operation information processing terminal.

As one of the preferred solutions, the process of receiving, by the vehicle simulation system, a functional instruction set obtained through a user's operation on a vehicle control instruction block, specifically includes:
checking, by the vehicle simulation system, in response to an operational instruction of the user, whether the vehicle control instruction block meets a predefined operational condition of vehicle control instruction block; the operational condition of vehicle control instruction block includes: the vehicle control instruction block has a concatenatable attribute or a splittable attribute; the operational instruction includes: a concatenating instruction or a splitting instruction;
performing a control operation of the vehicle control instruction block corresponding to the operational instruction to obtain the functional instruction set if the vehicle control instruction block meets the operational condition; the control operation includes accordingly: concatenating or splitting the vehicle control instruction block that meets the operational condition of vehicle control instruction block.

As one of the preferred solutions, the operational instruction includes the concatenating instruction, and a first vehicle control instruction block and a second vehicle control instruction block have the concatenatable attribute;
in this case, the process of performing a control operation of the vehicle control instruction block corresponding to the operational instruction to obtain the functional instruction set includes:
providing a ready-to-concatenate prompt when the first vehicle control instruction block and the second vehicle control instruction block meet the operational condition of vehicle control instruction block; and
concatenating the first vehicle control instruction block and the second vehicle control instruction block into a third vehicle control instruction block when a state of the first vehicle control instruction block is changed from a selected state to an unselected state.

As one of the preferred solutions, the method further includes:
controlling the second vehicle control instruction block to move along with the first vehicle control instruction block when the first vehicle control instruction block within the third vehicle control instruction block is selected to move; wherein, in the third vehicle control instruction block, the first vehicle control instruction block is a front vehicle control instruction block, the second vehicle control instruction block is a back vehicle control instruction block.

As one of the preferred solutions, the method further includes:
splitting the third vehicle control instruction block into the first vehicle control instruction block and the second vehicle control instruction block when the second vehicle control instruction block within the third vehicle control instruction block is selected to move, and controlling the second vehicle control instruction block to move separately.

As one of the preferred solutions, the method further includes:
receiving, by the vehicle simulation system, a first execution time point of the first vehicle control instruction block and a second execution time point of the second vehicle control instruction block within the third vehicle control instruction block; converting the first vehicle control instruction block into a first vehicle control instruction fragment and converting the second vehicle control instruction block into a second vehicle control instruction fragment, concatenating the first vehicle control instruction fragment and the second vehicle control instruction fragment in a sequential order based on a sequential execution order of the first execution time point and the second execution time point to obtain the functional instruction set.

As one of the preferred solutions, the method further includes:
receiving, by the vehicle simulation system, a first execution time point of the first vehicle control instruction block and a second execution time point of the second vehicle control instruction block within the third vehicle control instruction block; converting the first vehicle control instruction block into a first vehicle control instruction fragment and converting the second vehicle control instruction block into a second vehicle control instruction fragment, concatenating the first vehicle control instruction fragment and the second vehicle control instruction fragment in a reverse order based on a sequential execution order of the first execution time point and the second execution time point to obtain the functional instruction set.

As one of the preferred solutions, the method further includes:
receiving, by the vehicle simulation system, the first vehicle control instruction block and the second vehicle control instruction block within the third vehicle control instruction block, converting the first vehicle control instruction block into a first vehicle control instruction fragment and converting the second vehicle control instruction block into a second vehicle control instruction fragment, concatenating the first vehicle control instruction fragment and the second vehicle control instruction fragment in a random order to obtain the functional instruction set.

As one of the preferred solutions, the method further includes:
during converting the third vehicle control instruction block, skipping, by the vehicle simulation system, the conversion of the first vehicle control instruction block if the first vehicle control instruction block has a disabled attribute, skipping the conversion of the second vehicle control instruction block if the second vehicle control instruction block has a disabled attribute.

As one of the preferred solutions, the process of integrating and converting, by the vehicle simulation system, the functional instruction set and the inside-and-outside-vehicle environmental parameter into an instruction execution sequence, specifically includes:
verifying the functional instruction set;
converting the functional instruction set into a simulation instruction based on a preset conversion relationship when the verification is passed;
integrating the simulation instruction and the inside-and-outside-vehicle environmental parameter into the instruction execution sequence.

As one of the preferred solutions, the process of verifying the functional instruction set, specifically includes:
checking whether each functional instruction in the functional instruction set is a valid functional instruction;
if it is, checking whether corresponding user-set parameters for each functional instruction are valid parameters;
if they are, determining that the verification is passed.

As one of the preferred solutions, the process of converting the functional instruction set into a simulation instruction based on a preset conversion relationship, specifically includes:
extracting each functional instruction from the functional instruction set, converting each of the functional instruction into a simulation instruction fragment according to the preset conversion relationship, concatenating all the simulation instruction fragments to obtain the simulation instruction.

As one of the preferred solutions, the preset conversion relationship includes:
extracting each functional instruction one by one according to a sequential combination order of the functional instructions within the functional instruction set;
concatenating all the simulation control instruction fragments one by one according to the sequential combination order.

As one of the preferred solutions, the preset conversion relationship includes:
extracting each functional instruction one by one according to a sequential order of the execution timings of the functional instructions within the functional instruction set;
concatenating all the simulation control instruction fragments one by one according to the sequential order of the execution timings.

As one of the preferred solutions, the preset vehicle model is a 3D vehicle model.

As one of the preferred solutions, the method further includes:
receiving a timeline representing duration of the presentation animation;
overlaying the timeline on a preset progress bar to obtain a time progress bar of the presentation animation.

As one of the preferred solutions, the method further includes:
providing a modification suggestion based on the presentation effect image and/or the presentation animation.

As one of the preferred solutions, the method further includes:
checking whether the presentation effect image and/or the presentation animation aligns with an expected outcome of the preset vehicle model executing the functional instruction set under the inside-and-outside-vehicle environmental parameter;
if it does not, pushing a simulation emulation error notification.

In a second aspect, an embodiment of the present invention provides an emulation apparatus for a vehicle simulation system, the apparatus includes:
a receiving module, configured to receive an inside-and-outside-vehicle environmental parameter and a functional instruction set obtained through a user's operation on a vehicle control instruction block;
a converting module, configured to integrate and convert the functional instruction set and the inside-and-outside-vehicle environmental parameter into an instruction execution sequence;
a rendering module, configured to render a preset vehicle model according to the instruction execution sequence to obtain a presentation effect image and/or a presentation animation of the preset vehicle model executing the functional instruction set under the inside-and-outside-vehicle environmental parameter.

In a third aspect, an embodiment of the present invention provides a vehicle server, including:
a memory, configured to store a computer program;
a processor, configured to execute the computer program;
wherein, when executing the computer program, the processor implements the emulation method for a vehicle simulation system as described above.

In a fourth aspect, an embodiment of the present invention provides a terminal device, including a memory, a processor, and a computer program stored in the memory and executable on the processor; when executing the computer program, the processor implements the emulation method for a vehicle simulation system as described above.

In a fifth aspect, an embodiment of the present invention provides a vehicle, wherein the vehicle includes the terminal device as described above.

In a sixth aspect, an embodiment of the present invention provides a vehicle control system, including a vehicle simulation system and a vehicle control system;
the vehicle simulation system is configured to perform the emulation method for a vehicle simulation system as described above;
the vehicle-mounted control system is configured to control a vehicle's controlled component corresponding to the functional instruction set to execute synchronously a vehicle control instruction corresponding to the functional instruction set while the vehicle simulation system obtains the presentation effect image and/or presentation animation.

As a preferred solution, the vehicle simulation system has a first operating terminal;
the process of receiving, by the vehicle simulation system, a functional instruction set obtained through a user's operation on a vehicle control instruction block, specifically includes:
operating, by the user, the vehicle control instruction block through the first operating terminal;
sending, by the first operating terminal, an operation result to the vehicle simulation system enabling the vehicle simulation system to obtain the functional instruction set.

As one of the preferred solutions, the first operating terminal is a central console of the vehicle.

As one of the preferred solutions, the vehicle control system further includes a user terminal system;
the user terminal system has a second operating terminal for the user to operate the vehicle control instruction block, and the user terminal system is configured to send the operation result to the vehicle simulation system and the vehicle-mounted control system, respectively.

As one of the preferred solution, the second operating terminal is a mobile human-machine interaction device, and the mobile human-machine interaction device is a mobile phone, a laptop, or a tablet.

In a seventh aspect, an embodiment of the present invention provides a computer-readable storage medium, the computer-readable storage medium stores a computer program, wherein when the computer program runs, a device in which the computer-readable storage medium is located is controlled to perform the emulation method for a vehicle simulation system as described above.

Compared with the prior art, the beneficial effects of the embodiments of the present invention include at least one of the following points: users can visually concatenate the functional instructions, combine them into a functional instruction set, this functional instruction set includes execution operations of multiple controlled components of the vehicle, allowing for coordinated control of the vehicle through a single functional instruction set. furthermore, the control effects of the coordinated control are presented through a preset vehicle model for preview, allowing users to gain advance insight into the control effects of the functional instruction set so as to make corresponding modifications or confirm the functional instruction set without the need to understand the control effects of the functional instruction set through the actual operation of the vehicle. This enhances the intelligent level of vehicle control, saves users' time and effort, and enhances the user experience; additionally, the emulation method for a vehicle simulation system does not require direct control of the vehicle, users without a vehicle can also create the functional instruction set and observe its control effects, this is convenient for users without a vehicle to gain advance insight into the intelligent control effects of the vehicle, providing a channel to gain advance insight into the vehicle for the users without a vehicle.

### BRIEF DESCRIPTION OF THE DRAWINGS

FIG. 1 is a schematic flowchart of an emulation method for a vehicle simulation system according to one of the embodiments of the present invention.
FIG. 2 is a schematic diagram of a structure of an emulation apparatus for a vehicle simulation system according to one of the embodiments of the present invention.
FIG. 3 is a structural block diagram of a terminal device according to one of the embodiments of the present invention.

Reference signs in the drawings:
11. receiving module; 12. converting module; 13. rendering module; 21. processor; 22. memory.

### DETAILED DESCRIPTION OF THE INVENTION

Now with reference to the drawings in the embodiments of the present invention, the technical solutions of the embodiments of the present invention will be described clearly and comprehensively. Clearly, the described embodiments are only part of the embodiments of the present invention, not all of them. These embodiments are provided for the purpose of making the disclosure of the present invention more thorough and comprehensive. Based on the embodiments of the present invention, all other embodiments obtained by those skilled in the art without inventive effort are within the scope of protection of the present invention.

In the description of this application, the terms "first," "second," "third," and the like are used for descriptive purposes only and should not be understood as indicating or implying the relative importance or implying the quantity of the indicated technical features. Thus, features labeled with "first," "second," "third," and the like may explicitly or implicitly include one or more of that feature. In the description of this application, unless otherwise specified, the meaning of "a plurality of" is two or more.

In the description of this application, it should be noted that, unless otherwise explicitly defined or limited, the terms "mount", "connect", "couple" should be broadly interpreted. For example, they may refer to fixed connections, detachable connections, or integral connections; they may refer to mechanical connections or electrical connections; they may refer to direct connections or indirect connections through an intermediate medium, and they may refer to communication within two components. The terms "vertical", "horizontal", "left", "right", "up", "down" and similar expressions used in this application are for illustrative purposes and do not indicate or imply that the apparatus or element referred to must have a specific orientation, or be constructed or operated in a specific orientation, and therefore should not be construed as limiting to the present invention. The term "and/or" used in this application includes any or all combinations of one or more of the listed items. For those skilled in the art, the specific meaning of the above terms in this application can be understood according to the specific situation.

In the description of this application, it should be noted that, unless otherwise defined, all the technical and scientific terms used in the present invention have the same meaning as understood by those skilled in the art. The terms used in the description of the present invention are for the purpose of describing specific embodiments and are not intended to limit the present invention. For those skilled in the art, the specific meaning of the above terms in this application can be understood according to the specific situation.

It should be noted that in the embodiments of the present invention, functional instructions can be combined, and this combination is user-visualizable. As an example, the functional instructions are designed in the form of building blocks, but the embodiments of the present invention are not limited to this and they can also be designed in the form of patterns among other possibilities. When the functional instructions are in the form of building blocks, the user can drag and stack these building blocks to concatenate multiple functional instructions into a functional instruction set. In other words, by concatenating and stacking the functional instructions, a complete function instruction set is formed, allowing coordinated control of multiple controlled components of the vehicle or coordinated control of multiple vehicles. Additionally, the control effects of this functional instruction set can be presented through a preset vehicle model, enabling users to gain advance insight so as to make corresponding modifications or confirm the functional instruction set. Wherein, the preset vehicle model is constructed based on a real vehicle by a certain scale, and corresponds to the vehicle type. The state of the components of the vehicle model can be updated by collecting the state of corresponding controlled components of a real vehicle so as to ensure that the states of the two are synchronized.

In the embodiments of the present invention, some functional instructions have associated correspondences with the controlled components of the vehicle, corresponding components of the vehicle model, and the execution actions they perform. Some functional instructions are used for condition check, while some functional instructions are solely for executing an operation, such as a delay operation, a loop operation, and so on.

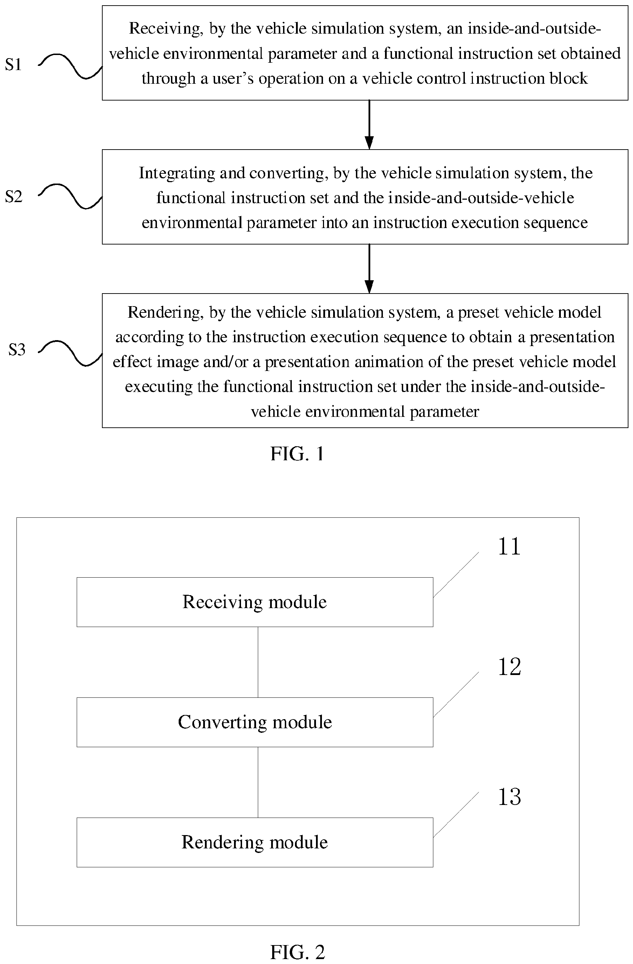

An embodiment of the present invention provides an emulation method for a vehicle simulation system. For details, please refer to FIG. 1. FIG. 1 illustrates a schematic flowchart of an emulation method for a vehicle simulation system according to one of the embodiments of the present invention. The method includes steps S1-S3:
S1, receiving, by the vehicle simulation system, an inside-and-outside-vehicle environmental parameter and a functional instruction set obtained through a user's operation on a vehicle control instruction block;
S2, integrating and converting, by the vehicle simulation system, the functional instruction set and the inside-and-outside-vehicle environmental parameter into an instruction execution sequence;
S3, rendering, by the vehicle simulation system, a preset vehicle model according to the instruction execution sequence to obtain a presentation effect image and/or a presentation animation of the preset vehicle model executing the functional instruction set under the inside-and-outside-vehicle environmental parameter.

When implementing the present invention, the first step is to receive the user-set functional instruction set and the inside-and-outside-vehicle environmental parameter. Wherein, the functional instruction set may be created by the user, or pre-constructed by developers and selected by the user; the inside-and-outside-vehicle environmental parameter represents the internal and external conditions of the vehicle, such as weather conditions and road conditions. The next step is to integrate and convert the functional instruction set and the inside-and-outside-vehicle environmental parameter into the instruction execution sequence, and call the preset vehicle model through a Javascript API interface. Then, by rendering the preset vehicle model according to the instruction execution sequence, the rendering result is obtained, wherein the rendering result is the presentation effect image and/or the presentation animation of the preset vehicle model executing the functional instruction set under the inside-and-outside-vehicle environmental parameter. Finally, the rendering result is presented in the display interface for the user to preview.

The embodiment of the present invention provide an emulation method for a vehicle simulation system, allowing users to visually concatenate the functional instructions (the functional instruction is namely the vehicle control instruction block in Step 1), combine them into a functional instruction set, this functional instruction set includes execution operations for multiple controlled components of the vehicle, allowing for coordinated control of the vehicle through a single functional instruction set. furthermore, the control effects of the coordinated control are presented through the preset vehicle model for preview, allowing users to gain advance insight into the control effects of the functional instruction set so as to make corresponding modifications or confirm the functional instruction set without the need to understand the control effects of the functional instruction set through the actual operation of the vehicle. This enhances the intelligent level of vehicle control, saves users' time and effort, and enhances the user experience; additionally, the emulation method for a vehicle simulation system does not require direct control of the vehicle, users without a vehicle can also create the functional instruction set and observe its control effects, this is convenient for users without a vehicle to gain advance insight into the intelligent control effects of the vehicle, providing a channel to gain advance insight into the vehicle for the users without a vehicle.

Furthermore, in the above embodiment, before the process of receiving, by the vehicle simulation system, an inside-and-outside-vehicle environmental parameter and a functional instruction set obtained through a user's operation on a vehicle control instruction block, the method further includes:
downloading, by the vehicle simulation system, a software package of the vehicle control instruction block based on OTA technology;
processing, by the vehicle simulation system, the software package of the vehicle control instruction block to obtain the vehicle control instruction block for the user to operate.

In the present invention, the download of the software package of the vehicle control instruction block is used for updating the vehicle control instruction block. The entities for executing this include the vehicle simulation system and the vehicle server. The vehicle simulation system communicates with the vehicle server through a Tbox. The vehicle simulation system is connected to the Tbox via a CAN bus or Ethenet. The Tbox is connected to the vehicle server via a wireless network. However, one skilled in the art should understand that the concept of the present invention can also be applied to other objects requiring updates.

To be more specific, when implementing the present invention, firstly, the vehicle simulation system sends a download request for the software package of the vehicle control instruction block to a vehicle server; when the vehicle server sends back version options for the software package of the vehicle control instruction block according to the download request, the vehicle simulation system receives the version options and displays them to the user; when the user selects a target version from the version options and confirms it, the version information of the target version is sent to the vehicle server, then the vehicle server sends back to the vehicle simulation system a download address of the target software package of the vehicle control instruction block corresponding to the version information of the target version; finally, the vehicle simulation system downloads the target software package of the vehicle control instruction block according to the download address. Certainly, the vehicle simulation system is built in the vehicle control system (or vehicle-mounted control system) and is a part of the vehicle control system (or vehicle-mounted control system), they will not be distinguished in the following text.

Here, the download request may be initiated by the user or may be automatically sent by the vehicle simulation system after the vehicle simulation system is connected to the vehicle server; the version options include the latest version and historical versions of the vehicle control command block and are displayed to the user in the form of a list; additionally, in the version options, a brief description of the software package of the vehicle control instruction is provided for each version; the download address points to a download server or a CDN (Content Delivery Network).

Furthermore, during OTA transmission, to mitigate the impact of external interference or other factors that may cause download abnormalities or interruptions, the vehicle simulation system further supports software rollback, resuming from a break point, retransmitting lost data, and other handling mechanism.

As an example, suppose the software version of the vehicle control instruction block of the vehicle simulation system is Version 1.1.12, the software versions of the vehicle control instruction blocks of the vehicle server include Version 1.1.1-Version 1.1.15; when the vehicle simulation system performs a version detection, if a new version is detected, the vehicle simulation system prompts the user, and when the user confirms the download of the software package, the vehicle simulation system sends the download request to the vehicle server and receives the version options sent back from the vehicle server according to the download request; when the user selects the target version and confirms it, for example, the user selects Version 1.1.15 expecting to experience new features, version information of that version is sent to the vehicle server, and the target software package of the vehicle control instruction block is downloaded according to the download address sent back from the vehicle server. If the user, after using Version 1.1.15 for a while, feels uncomfortable and believes Version 1.1.12 better suits his usage habits, the user can initiate a download request and select Version 1.1.12 from the version options, so as to download the software package of the vehicle control instruction block with a version number of Version 1.1.12

Regarding the above-mentioned download of the software package of the vehicle control instruction block in the embodiments of the present invention, when a user needs to download a software package, the version options of the software package are provided, and after the user selects the target version, the target software package corresponding to that target version is downloaded. This improves the flexibility of version selection during software package downloads and is convenient for the user to select the version of software package to be downloaded, and allows the user to select the version of the software package based on his usage habits, thereby enhancing the user's driving experience.

In a preferred embodiment, the process of downloading the target software package of the vehicle control instruction block according to the download address, specifically includes:
detecting whether there is a download task for a software package with higher priority;
if there is a download task for a software package with higher priority, downloading the software package with higher priority;
if there is not a download task for a software package with higher priority, further detecting whether there is an existing download task for a software package with the same priority;
if there is an existing download task for a software package with the same priority, downloading the software package with the same priority;
if there is not an existing download task for a software package with the same priority, downloading the target software package of the vehicle control instruction block according to the download address.

As an example, the software package of the vehicle control system is configured with a priority during download. For instance, software packages related to system security may have a higher priority than the software packages of the vehicle control instruction blocks. When downloading the software package of the vehicle control instruction block, if a download task for another software package is detected, a comparison of their download priorities will be conducted, and priority sorting will be performed, and the corresponding software packages will be downloaded in order of priority.

The present embodiment downloads the software packages in order of priority, ensuring vehicle stability and enhancing security.
In a preferred embodiment, the download request includes a device identifier of the vehicle, current version information of the software package of the vehicle control instruction block of the vehicle, and version authentication information corresponding to the current version information;
wherein the device identifier, the current version information, and the version authentication information corresponding to the current version information are used for the vehicle server to authenticate the download request.

To be more specific, the download request includes a series authentication signal used for the vehicle server to authenticate the download request, the series authentication signal is namely the device identifier of the vehicle, the current version information of the software package of the vehicle control instruction block of the vehicle, and the version authentication information corresponding to the current version information. After receiving the download request, the vehicle server first performs matching on the device identifier, verifies whether the vehicle is a valid vehicle, and seeks out the vehicle control instruction block supported by that vehicle; then performs matching on the current version information, verifies whether the version number of the software package of the vehicle control instruction block is a valid version number; finally performs authentication on the version authentication information, and determines that the authentication is passed if the version authentication information successfully matches a stored version authentication information, and sends the version options of the vehicle control instruction block supported by the vehicle.

Here, each version of the software package of the vehicle control instruction block has a corresponding version authentication information.

The present embodiment adds the device identifier, the version information and the version authentication information into the download request, enhancing the confidentiality and security of OTA transmission, avoiding errors in sending software packages that might affect the normal operation of the vehicle.

As an improvement of the above embodiments, after the process of downloading the target software package of the vehicle control instruction block according to the download address, the method further includes:
loading, by the vehicle simulation system, the target software package of the vehicle control instruction block, updating the current version information to the version information of the target software package of the vehicle control instruction block, and updating the version authentication information corresponding to the current version information to the version authentication information corresponding to the target software package of the vehicle control instruction block.

In the present embodiment, the target software package of the vehicle control instruction block includes the version information of the target software package of the vehicle control instruction block and the version authentication information corresponding to the target software package of the vehicle control instruction block, therefore, after updating the version of the vehicle control instruction block, the present embodiment also updates the version authentication information so as to facilitate authentication during the next software package download.

In a preferred embodiment, a plurality of download addresses are provided; in this case,
the process of downloading the target software package of the vehicle control instruction block according to the download address, specifically includes:
receiving a download speed of the target software package of the vehicle control instruction block at a current selected download address;
switching to a different download address to download the target software package of the vehicle control instruction block when there is an anomaly in the download speed.

In the present embodiment, the vehicle end receives a plurality of download addresses. The vehicle end may randomly choose one from the download addresses as the current selected download address for software package download or choose the one with the least load from the download addresses as the current selected download address for software package download. The present embodiment doesn't impose specific restrictions. During software package download, the vehicle end monitors the download speed of the software package at the current selected address, and checks whether the download speed has remained at a low speed value for a long time; if it has not, continues the download; if it has, determines that there is an anomaly in the download speed, and chooses another download address from the plurality of addresses, switches the current download address to the newly chosen address for software package download, meanwhile keeps monitoring the download speed.

The present embodiment monitors the download speed at the selected download address during software package download, enabling automatically switch of the download address when there is an anomaly, thereby reducing the time for software package download.

In a preferred embodiment, the process of downloading the target software package of the vehicle control instruction block according to the download address, specifically includes:
downloading all program blocks of the target software package of the vehicle control instruction block according to the download address and a pre-set download order of the program blocks of the target software package of the vehicle control instruction block.

In the present embodiment, the target software package of the vehicle control instruction block has a pre-set download order for the program blocks of the target software package of the vehicle control instruction block, wherein the download order may be set according to the size of the program blocks, or the functionality of the program block. The present embodiment doesn't impose specific restrictions.

As an improvement of the above embodiments, the process of downloading all program blocks of the target software package of the vehicle control instruction block according to the download address and a pre-set download order of the program blocks of the target software package of the vehicle control instruction block, specifically includes:
downloading the program block of the target software package of the vehicle control instruction block according to the download address and a pre-set download order of program blocks of the target software package of the vehicle control instruction block and receiving the download speed of the program block;
choosing a next program block in the download order for downloading when there is an anomaly in the download speed until all the program blocks of the target software package of the vehicle control instruction block are downloaded.

Based on the previous embodiment, the present embodiment also monitors the download speed of the program block, checks whether the download speed has remained at a low speed value for a long time (the time and the low speed value are set according to actual circumstances); if it has not, continues the download; if it has, determines that there is an anomaly in the download speed, and chooses the next download address in the download order for downloading, and monitors its download speed; if an anomaly is still there, keeps switching. This process continues until all program blocks are downloaded.

The present embodiment schedules the program blocks with slower download speed in the latter part of the download process, resulting in a smoother download speed for the entire download process.

In a preferred embodiment, the process of downloading the target software package of the vehicle control instruction block according to the download address, specifically includes:
verifying validity of the download address;
downloading the target software package of the vehicle control instruction block when the download address is valid.

In the present embodiment, after receiving the download address from the vehicle server, the vehicle end first verifies the download address, checks whether the download address is a valid address (an address with secure authentication); if it is not, cancels the download; if it is, downloads the target software package of the vehicle control instruction block.

After receiving the download address, the present embodiment further verifies the download address, thereby enhancing the security of software package download, avoiding the downloading of software packages from invalid download addresses that might affect the normal operation of the vehicle.
As an improvement of the above embodiments, the target software package of the vehicle control instruction block is encrypted; in this case,
after the process of downloading the target software package of the vehicle control instruction block according to the download address, the method further includes:
decrypting the target software package of the vehicle control instruction block to obtain a decrypted target software package of the vehicle control instruction block;
verifying validity of the decrypted target software package of the vehicle control instruction block;
loading the decrypted target software package of the vehicle control instruction block when the decrypted target software package of the vehicle control instruction block is valid.

Here, in the process of verifying the validity of the decrypted target software package of the vehicle control instruction block, the decrypted target software package is matched with version of the vehicle control system. For example, in a case where the vehicle control system used by the user's vehicle hasn't been upgraded for a long time and is of a lower version, but the user chooses the latest version of the target software package of the vehicle control instruction block, then since the latest version of the target software package of the vehicle control instruction block is designed for the new version of vehicle control system, so the vehicle control system used by the user's vehicle is not compatible with the latest version of the target software package of the vehicle control instruction block (may result in system lag, etc.), therefore the target software package of the vehicle control instruction block is determined invalid, its loading is canceled, and a notification is prompted to the user.

In the present embodiment, the target software package of the vehicle control instruction block from the download address is encrypted. After the download is completed, the vehicle end first needs to decrypt it to obtain the decrypted target software package of the vehicle control instruction block and then verifies the decrypted software package, checks whether the vehicle control instruction block is compatible with the current vehicle; if it is not, cancels the loading of the software package; if it is, loads the software package.

After downloading the encrypted software package, the present embodiment decrypts it and verifies its validity, further enhancing the security of software package download.

In the present embodiment, the method further includes:
receiving, by the vehicle server, the user's operation information for the vehicle simulation system;
storing, by the vehicle server, the operation information.

Furthermore, the process of storing, by the vehicle server, the operation information, specifically includes:
checking, by the vehicle server, whether there is an anomaly in the operation information;
storing, by the vehicle server, the operation information on a disk as an abnormal operation information if there is an anomaly in the operation information;
storing, by the vehicle server, the operation information on the disk as a normal operation information if there is no anomaly in the operation information and recording a storing time.

Furthermore, after the process of storing, by the vehicle server, the operation information on a disk as an abnormal operation information, the method further includes:
checking, by the vehicle server, an anomaly level of the abnormal operation information;
sending, by the vehicle server, the abnormal operation information to an abnormal operation information processing terminal when the anomaly level meets a preset anomaly level condition.

Here, in the process of receiving the user's operation information, what is received is all the user's operation information for the vehicle control instruction block; the abnormal operation information processing terminal is a terminal device owned by an administrator such as a mobile phone or a personal computer. When the administrator receives the abnormal operation information that meets the preset anomaly level, he imports this information into a sandbox system. This enables a 100% restoration of the user's operation scenario at that time, facilitating the quick resolution of anomalies.

To be more specific, when the user operates the vehicle control instruction block through the vehicle simulation system, the vehicle server receives the user's operation information for the vehicle control instruction block, checks whether there is an anomaly in the operation information; if there is an anomaly in the obtained operation information, stores the operation information on the local disk as an abnormal operation information, and further checks the anomaly level of the abnormal operation information; if it determines that the anomaly level of the abnormal operation information meets the preset anomaly level condition, it sends the abnormal operation information directly to the administrator's terminal device via email etc., so that the administrator can promptly address the abnormal operation information.

As an example, the anomaly level includes high-risk anomaly degree, medium anomaly degree, and common anomaly degree; the preset anomaly level condition is: the anomaly level is high-risk anomaly degree. In this case, the present invention sends the operation information directly to the administrator's terminal device only when the anomaly level of the operation information is determined as high-risk anomaly degree.

Furthermore, in the above embodiments, the process of checking, by the vehicle server, whether there is an anomaly in the operation information, specifically includes:
checking, by the vehicle server, whether the vehicle control instruction block is a registered valid vehicle control instruction block;
determining, by the vehicle server, that there is an anomaly in the operation information if the vehicle control instruction block is not a valid vehicle control instruction block;
checking, by the vehicle server, whether a version of the vehicle control instruction block is the current version if the vehicle control instruction block is a valid vehicle control instruction block;
determining, by the vehicle server, that there is an anomaly in the operation information if the version is not the current version;
checking, by the vehicle server, whether a parameter configured in the vehicle control instruction block exceeds a parameter threshold range if the version is the current version;
determining, by the vehicle server, that there is an anomaly in the operation information if the parameter exceeds the parameter threshold range;
determining, by the vehicle server, that there is no anomaly in the operation information if the parameter doesn't exceed the parameter threshold range;

Here, the server (vehicle server) stores all registered vehicle control instruction blocks (including those pre-created by a developer and those created by the user). These vehicle control instruction blocks are server-recognized valid vehicle control instruction block, and every vehicle control instruction block has a corresponding version number.

As an example, the user created a new vehicle control instruction block 1 on a vehicle-mounted terminal through the vehicle simulation system, that vehicle control instruction block 1 has not been registered in the server, but the user directly uses that vehicle control instruction block 1 to control the vehicle, in this case it can be determined that there is an anomaly in the user's operation information.

As another example, the user selects a version number of Version 1.1.12 for the vehicle control instruction block on the vehicle-mounted terminal through the vehicle simulation system, and the user downloads a functional instruction set uploaded by another user, however the version number of the vehicle control instruction block used by that functional instruction set is Version 1.1.14, and the user directly uses that functional instruction set to control his own vehicle, in this case it can be determined that there is an anomaly in the user's operation information.

As another example, the user configures parameters for vehicle control instruction block 2 on the vehicle-mounted terminal, the vehicle control instruction block 2 is used to control the movement of the vehicle's seat, the threshold range of the movement is 0~5cm, however the user inputs a parameter of 8 cm which exceeds the threshold range, in this case it can be determined that there is an anomaly in the user's operation information.

In a preferred embodiment, the process of storing, by the vehicle server, the operation information on the disk as a normal operation information if there is no anomaly in the operation information and recording a storing time, specifically includes:
compressing, by the vehicle server, the operation information through a preset compression algorithm if there is no anomaly in the operation information;
storing, by the vehicle server, the compressed operation information on the disk as a normal operation information and recording the storing time.

To be more specific, in order to minimize the occupied space of the disk, the present embodiment further compresses the normal operation information, then stores the compressed operation information on the disk and records the storing time.

In a preferred embodiment, the method further includes:
checking, by the vehicle server, whether a usage rate of the disk is greater than a usage rate threshold;
deleting, by the vehicle server, the normal operation information according to the storing time if the usage rate is over the usage rate threshold.

After storing the operation information, the present embodiment monitors the disk usage and compares the usage rate of the disk with the usage rate threshold. If the usage rate is greater than the usage rate threshold, then it is determined that there is limited space on the disk, and a cleanup is required. Then, the normal operation information is deleted according to a "first stored, first deleted" principle until the usage rate of the disk falls below the usage rate threshold or until the usage rate of the disk falls below a storage rate threshold. Wherein, the storage rate threshold is less than the usage rate threshold.

In a preferred embodiment, the anomaly level dynamically increases and decreases according to a frequency of occurrence of a type of the abnormal operation information.

In the present embodiment, the anomaly level of the abnormal operation information is not fixed, but dynamically increases and decreases according to the frequency of occurrence of the type of the abnormal operation information. This enables the classification based on the actual circumstances of the anomaly type, making it easier for the administrator to prioritize the more frequently occurring anomaly types for processing.

As an example, the types of the abnormal operation information include: Type 1: the vehicle control instruction block is invalid, Type 2: the vehicle control instruction block does not belong to the current version, Type 3: the parameter of the vehicle control instruction block exceeds the threshold. Within a preset time period, if the frequency of occurrence of Type 1 abnormal operation information exceeds a first frequency threshold, the anomaly level of Type 1 is determined as the high-risk anomaly degree; if it does not exceed the first frequency threshold, it the anomaly level of Type 1 is not determined as high-risk anomaly degree, and it is further determined as either a medium anomaly degree or common anomaly degree according to its frequency. Within a preset time period, if the frequency of Type 2 abnormal operation information exceeds a second frequency threshold, the anomaly level of Type 2 is determined as the high-risk anomaly degree. If it does not exceed the second frequency threshold, the anomaly level of Type 2 is not determined as high-risk anomaly degree, it is further determined as either a medium anomaly degree or common anomaly degree according to its frequency. Within a preset time period, if the frequency of Type 3 abnormal operation information exceeds a third frequency threshold, the anomaly level of Type 3 is determined as the high-risk anomaly degree. If it does not exceed the third frequency threshold, the anomaly level of Type 3 is not determined as high-risk anomaly degree, and it is further determined as either a medium anomaly degree or common anomaly degree according to its frequency.

In a preferred embodiment, the process of sending the abnormal operation information to an abnormal operation information processing terminal, specifically includes:
encrypting the abnormal operation information and setting a permission level, and then sending the abnormal operation information to the abnormal operation information processing terminal.

In the present embodiment, before sending the abnormal operation information to the abnormal operation information processing terminal, the abnormal operation information is encrypted, and its permission level is set. This prevents data interception or tampering and enhances the security of data transmission

In the present embodiment, the process of obtaining a functional instruction set through a user's operation on a vehicle control instruction block, specifically includes:
checking, by the vehicle simulation system, in response to a user-issued operational instruction, whether the vehicle control instruction block meets a predefined operational condition of vehicle control instruction block; the operational condition of vehicle control instruction block includes: the vehicle control instruction block has a concatenatable attribute or a splittable attribute; the operational instruction includes: a concatenating instruction or a splitting instruction;
performing a control operation of the vehicle control instruction block corresponding to the operational instruction to obtain the functional instruction set if the vehicle control instruction block meets the operational condition; the control operation includes, accordingly: concatenating or splitting the vehicle control instruction block that meets the operational condition of vehicle control instruction block.

It should be noted that, in the present invention, some vehicle control instruction blocks have associated correspondences with the controlled components of the vehicle, and the actions they perform, such as opening the front door, closing the front door and so on; some vehicle control instruction blocks are used for conditional check, such as gear check and so on, while some vehicle control instruction blocks are solely for executing an operation, such as a delay operation, a loop operation, and so on. Wherein, before establishing associated correspondences between the vehicle control instruction blocks and the controlled components of vehicle, it's necessary to know the states of the controlled components. As an example, the state of the vehicle seat includes moving in the forward, backward, left, right, up or down directions, as well as heating, massaging, and other states on. However, this invention is not limited to these. For example, it can also include expanding, contracting and other states. Therefore, during the process of establishing the associated correspondences, the first step is to modularize the controlled component and associate it with the vehicle control instruction block. Then, further associate the controlled component's state with the vehicle control instruction block's functional parameter. After the association, perform a verification test; if the test result does not meet expectations, store the vehicle control instruction block in an abnormal vehicle control instruction block database to enable direct error reporting for the next occurrence of the same vehicle control instruction block without the need for re-verification, and perform redesign; if the test result meets expectations, stores the vehicle control instruction block into a normal vehicle control instruction block database.

In the present invention, the vehicle control instruction blocks can be concatenated, and this concatenatation is user-visualizable. As an example, the vehicle control instruction blocks are designed in the form of building blocks, but the embodiments of the present invention are not limited to this and can also be designed in the form of patterns, among other possibilities. When the functional instructions are in the form of building blocks, the user can drag and stack these building blocks to concatenate multiple vehicle control instruction blocks thereby allowing coordinated control of multiple controlled components of the vehicle. Furthermore, after the vehicle control instruction blocks are concatenated, they can further be splitted. The user may split the concatenated vehicle control instruction block into multiple vehicle control instruction blocks.

To be more specific, when a vehicle control instruction block is selected by the user to perform a concatenating control, in response to a concatenating instruction of the vehicle control instruction block, the vehicle simulation system checks whether the vehicle control instruction block has the concatenatable attribute; if it has, performs an concatenating operation of the vehicle control instruction block. When a vehicle control instruction block is selected by the user to perform splitting control, in response to a spliting instruction of the vehicle control instruction block, checks whether the vehicle control instruction block has the splittable attribute; if it has, performs the splitting operation of the vehicle control instruction block.

It's understandable that if the vehicle control instruction block doesn't have the concatenatable attribute or the spilttable attribute, there is no need for further operations.

Wherein, in a case where the operational instruction includes the concatenating instruction, and a first vehicle control instruction block and a second vehicle control instruction block have the concatenatable attribute;
the process of performing a control operation of the vehicle control instruction block corresponding to the operational instruction includes:
providing a ready-to-concatenate prompt when the first vehicle control instruction block and the second vehicle control instruction block meet the control condition of instruction block; and
concatenating the first vehicle control instruction block and the second vehicle control instruction block into a third vehicle control instruction block when a state of the first vehicle control instruction block is changed from a selected state to an unselected state.

Wherein, the first vehicle control instruction block includes at least one vehicle control instruction block, that is to say, the first vehicle control instruction block may be a single vehicle control instruction block or a concatenated vehicle control instruction block obtained by concatenating multiple vehicle control instruction blocks; likewise, the second vehicle control instruction block includes at least one vehicle control instruction block, that is to say, the second vehicle control instruction block may be a single vehicle control instruction block or a concatenated vehicle control instruction block obtained by concatenating multiple vehicle control instruction blocks; the third vehicle control instruction block includes at least two vehicle control instruction blocks.

To be more specific, the present embodiment provides the ready-to-concatenate prompt when the first vehicle control instruction block and the second vehicle control instruction block meet the preset concatenation condition, and concatenates the first vehicle control instruction block and the second vehicle control instruction block only after the user cancels the selection of the first vehicle control instruction block. This allows the user to understand whether the vehicle control instruction blocks meet the concatenation condition and decide whether or not to cancel the concatenation, enhancing the user experience. Wherein, the ready-to-concatenate prompt can be provided through highlighting or be provided in text form.

Optionally, the method further includes:
providing the prompt at a concatenation point of the third vehicle control instruction block; wherein color or spacing or other forms can be used for the prompt.

It should be noted that, the concatenatable attribute includes a forward concatenatable attribute (meaning the vehicle control instruction block can be concatenated in the front), a backward concatenatable attribute (meaning the vehicle control instruction block can be concatenated at the back) and a forward-and-backward concatenatable attribute (meaning the vehicle control instruction block can be concatenated both in the front and at the back).

Preferably, in the process of concatenating, the concatenation condition includes: a distance between the vehicle control instruction blocks is less than or equal to a preset distance, or meets a backend recommended condition.

As an example, the user adds a vehicle control instruction block 1 and a vehicle control instruction block 2 on an edit page, the vehicle control instruction block 1 has the backward concatenatable attribute or the forward-and-backward concatenatable attribute. The user selects the vehicle control instruction block 1 and if the user drags the vehicle control instruction block 1 closer to the vehicle control instruction block 2 from above and the vehicle control instruction block 2 has the forward concatenatable attribute, then when the distance between them is less than or equal to the preset distance, it is determined that they are in the ready-to-concatenate state, and the vehicle control instruction block 1 is concatenated automatically with the vehicle control instruction block 2, forming a concatenated vehicle control instruction block of "vehicle control instruction block 1+ vehicle control instruction block 2". In addition, if the user drags the vehicle control instruction block 1 closer to the vehicle control instruction block 2 from below, since the vehicle control instruction block 2 doesn't have the backward concatenatable attribute, they cannot be concatenated at this time. Alternatively, the user selects a vehicle control instruction block 3 for controlling a left front door, this time the backend provides the user with a vehicle control instruction block 4 for opening a right front door, which is highly likely to be concatenated with based on a prediction. Then the vehicle control instruction block 4 is concatenated with the vehicle control instruction block 3, forming a concatenated vehicle control instruction block of "vehicle control instruction block 3 + vehicle control instruction block 4".

As another example, the user adds a concatenated vehicle control instruction block 5 and a vehicle control instruction block 6 on an edit page, the concatenated vehicle control instruction block 5 has the forward-and-backward concatenatable attribute. The user selects the concatenated vehicle control instruction block 5. If the user drags the concatenated vehicle control instruction block 5 closer to the vehicle control instruction block 6 from above and if the vehicle control instruction block 6 has the forward concatenatable attribute, then when the distance between them is less than or equal to the preset distance, it is determined that they are in the ready-to-concatenate state, and the concatenated vehicle control instruction block 5 is concatenated automatically with the vehicle control instruction block 6, forming a concatenated vehicle control instruction block of "concatenated vehicle control instruction block 5 + vehicle control instruction block 6". In addition, since the vehicle control instruction block 6 doesn't have the backward concatenatable attribute, it's impossible to form the concatenated vehicle control instruction of "vehicle control instruction block 6 + concatenated vehicle control instruction block 5" at this time. Likewise, if the vehicle control instruction block 6 has the backward concatenatable attribute, it can be concatenated with the concatenated vehicle control instruction block 5, forming a concatenated vehicle control instruction of "vehicle control instruction block 6 + concatenated vehicle control instruction block 5", but it is impossible to form a concatenated vehicle control instruction block of "concatenated vehicle control instruction block 5 + vehicle control instruction block 6". If the vehicle control instruction block 5 has the forward-and-backward concatenatable attribute, and if the user drags the vehicle control instruction block 5 closer to the vehicle control instruction block 6 from above, then when the distance between them is less than or equal to the preset distance, it is determined that they are in the ready-to-concatenate state, and the vehicle control instruction block 5 is concatenated automatically with the vehicle control instruction block 6, forming a concatenated vehicle control instruction block of "concatenated vehicle control instruction block 5 + vehicle control instruction block 6". If the user drags the concatenated vehicle control instruction block 5 closer to the vehicle control instruction block 6 from below, then when the distance between them is less than or equal to the preset distance, it is determined that they are in the ready-to-concatenate state, and the concatenated vehicle control instruction block 5 is concatenated automatically with the vehicle control instruction block 6, forming a concatenated vehicle control instruction block of "vehicle control instruction block 6 + concatenated vehicle control instruction block 5".

It should be noted that, if there are multiple second vehicle control instruction blocks around the first vehicle control instruction block, the second vehicle control instruction block having the minimum distance will be chosen to be concatenated with when the distances meet the concatenation condition.

As an example, the user adds a vehicle control instruction block 5, a vehicle control instruction block 6 and a vehicle control instruction block 7 on an edit page, all three of them have the forward-and-backward concatenatable attribute. The user selects the vehicle control instruction block 5 and drags the vehicle control instruction block 5 closer to the vehicle control instruction block 6 and the vehicle control instruction block 7. In this case if both the distance between the vehicle control instruction block 5 and the vehicle control instruction block 6 and the distance between the vehicle control instruction block 5 and the vehicle control instruction block 7 are less than the preset distance, the two distances are need to be further compared, and then the vehicle control instruction block 5 is concatenated with the vehicle control instruction block having the smaller distance.

The present embodiment provides users with vehicle control instruction blocks, allowing users to visually program vehicle control instructions, reducing the entry barrier for users to control a vehicle through programming, decreasing the complexity of writing vehicle control instructions for users, and enhancing the efficiency of user editing of vehicle control instructions. Meanwhile, the vehicle control instruction blocks have the concatenatable attribute, which means they can be concatenated into a concatenated vehicle control instruction block, achieving coordinated control of the controlled components of the vehicle. Moreover, the concatenated vehicle control instruction block is convenient for user to understand and modify as a whole, further enhancing the efficiency of user editing of vehicle control instructions. In addition, the vehicle control instruction blocks also have the splittable attribute, therefore the vehicle control instruction block can be splitted, making it convenient to modify the vehicle control instruction block, further enhancing the efficiency of user editing of vehicle control instructions.

In a preferred embodiment, the emulation method further includes:
controlling the second vehicle control instruction block to move along with the first vehicle control instruction block when the first vehicle control instruction block within the third vehicle control instruction block is selected to move; wherein, in the third vehicle control instruction block, the first vehicle control instruction block is a front vehicle control instruction block, the second vehicle control instruction block is a back vehicle control instruction block.

To be more specific, after concatenation to form the third vehicle control instruction block, due to the fact that the first vehicle control instruction block is the front vehicle control instruction block within the third vehicle control instruction block, the first vehicle control instruction block can drive the second vehicle control instruction block to move together. In other words, when the user selects the front control instruction block to move, the entire third vehicle control instruction block moves as a whole.

In this embodiment, by dragging the front vehicle control instruction block within the concatenated vehicle control instruction block, the concatenated vehicle control instruction block can be moved as a whole, avoiding the need to drag each control instruction block individually, further enhancing the efficiency of user editing of vehicle control instructions.

As an improvement of the above embodiments, the emulation method further includes:
splitting the third vehicle control instruction block into the first vehicle control instruction block and the second vehicle control instruction block when the second vehicle control instruction block within the third vehicle control instruction block is selected to move, and controlling the second vehicle control instruction block to move separately.

To be more specific, after concatenation to form the third vehicle control instruction block, due to the fact that the second vehicle control instruction block is the back vehicle control instruction block within the third vehicle control instruction block, so it cannot drive the front vehicle control instruction block to move together, but move separately. Nevertheless, dragging the second vehicle control instruction block can split the third vehicle control instruction block can into the first vehicle control instruction block and the second vehicle control instruction block, so as to remove the concatenation state between the two.

In this embodiment, by dragging the back vehicle control instruction block within the concatenated vehicle control instruction block, the concatenated vehicle control instruction block can be splitted, making it convenient to modify, add, or delete vehicle control instruction blocks.

In a preferred embodiment, the emulation method further includes:
receiving, by the vehicle simulation system, a first execution time point of the first vehicle control instruction block and a second execution time point of the second vehicle control instruction block within the third vehicle control instruction block; converting the first vehicle control instruction block into a first vehicle control instruction fragment and converting the second vehicle control instruction block into a second vehicle control instruction fragment, concatenating the first vehicle control instruction fragment and the second vehicle control instruction fragment in a sequential order based on a sequential execution order of the first execution time point and the second execution time point to obtain the functional instruction set.

It should be noted that, in the vehicle simulation system of the present invention, the vehicle control instruction block doesn't directly control the controlled components of vehicle. It first needs to be converted into a vehicle control instruction that the simulation system can read according to a preset conversion protocol, then the vehicle control instruction that the simulation system can read is used to control the controlled components of the vehicle in the simulation system.

To be more specific, in this embodiment, when editing vehicle control instruction blocks, two modes are provided for users, including a default mode and a timeline mode.

Here, in the default mode, the user does not need to set an execution time point for each vehicle control instruction block. During conversion, simply by converting each vehicle control instruction block into a corresponding vehicle control instruction fragment and by sequentially concatenating the vehicle control instruction block fragments according to the sequential concatenation order of the respective vehicle control instruction blocks within the concatenated vehicle control instruction block, the complete vehicle control instruction can be obtained.

In the timeline mode, the user need to set execution time points for each vehicle control instruction block. If not set, a default execution time point is the initial timing, and the user is prompted accordingly. During conversion, the execution time points for each vehicle control instruction blocks are received and sorted on the timeline. Then by converting each vehicle control instruction blocks into a corresponding vehicle control instruction fragment and by sequentially concatenating the vehicle control instruction block fragments according to the sequential order of the execution time points on the timeline, the complete vehicle control instruction can be obtained.

The present embodiment set execution time points for the vehicle control instruction blocks, enabling automatic vehicle control at predefined execution time points, meeting various user needs for vehicle control, and enhancing the user's driving experience.

In a preferred embodiment, the emulation method further includes:
receiving, by the vehicle simulation system, a first execution time point of the first vehicle control instruction block and a second execution time point of the second vehicle control instruction block within the third vehicle control instruction block; converting the first vehicle control instruction block into a first vehicle control instruction fragment and converting the second vehicle control instruction block into a second vehicle control instruction fragment, concatenating the first vehicle control instruction fragment and the second vehicle control instruction fragment in a reverse order based on a sequential execution order of the first execution time point and the second execution time point to obtain the functional instruction set.

In a preferred embodiment, the emulation method further includes:
receiving, by the vehicle simulation system, the first vehicle control instruction block and the second vehicle control instruction block within the third vehicle control instruction block, converting the first vehicle control instruction block into a first vehicle control instruction fragment and converting the second vehicle control instruction block into a second vehicle control instruction fragment, concatenating the first vehicle control instruction fragment and the second vehicle control instruction fragment in a random order to obtain the functional instruction set.

In addition to forward vehicle control based on the sequential execution order of the execution time points, the present invention also allows for reverse or random vehicle control, enhancing the enjoyment of vehicle control.

In a preferred embodiment, the emulation method further includes:
receiving, by the vehicle simulation system, a first execution time point of the first vehicle control instruction block and a second execution time point of the second vehicle control instruction block within the third vehicle control instruction block; converting the first vehicle control instruction block into a first simulation operational instruction fragment and converting the second vehicle control instruction block into a second simulation operational instruction fragment; concatenating the first simulation operational instruction fragment and the second simulation operational instruction fragment in a sequential order based on a sequential execution order of the first execution time point and the second execution time point to obtain the simulation operational instruction, and rendering the simulation operational instruction through a preset vehicle model to obtain a rendering result, and then presenting the rendering result.

In a preferred embodiment, the emulation method further includes:
receiving, by the vehicle simulation system, a first execution time point of the first vehicle control instruction block and a second execution time point of the second vehicle control instruction block within the third vehicle control instruction block; converting the first vehicle control instruction block into a first simulation operational instruction fragment and converting the second vehicle control instruction block into a second simulation operational instruction fragment; concatenating the first simulation operational instruction fragment and the second simulation operational instruction fragment in a reverse order based on a sequential execution order of the first execution time point and the second execution time point to obtain the simulation operational instruction, rendering the simulation operational instruction through a preset vehicle model to obtain a rendering result, and then presenting the rendering result.

In a preferred embodiment, the emulation method further includes:
receiving, by the vehicle simulation system, the first vehicle control instruction block and the second vehicle control instruction block within the third vehicle control instruction block, converting the first vehicle control instruction block into a first simulation operational instruction fragment and converting the second vehicle control instruction block into a second simulation operational instruction fragment; concatenating the first simulation operational instruction fragment and the second simulation operational instruction fragment in a random order to obtain the simulation operational instruction, and rendering the simulation operational instruction through a preset vehicle model to obtain a rendering result, and then presenting the rendering result.

In the present invention, the actual control effects of the vehicle control instruction blocks can be presented through the vehicle model, enabling users to gain advance insight into the actual control effects of the vehicle control instruction blocks so that they can make additions, deletions, and/or modifications accordingly.

In a preferred embodiment, the emulation method further includes:
during converting the third vehicle control instruction block, skipping, by the vehicle simulation system, the conversion of the first vehicle control instruction block if the first vehicle control instruction block has a disabled attribute, skipping the conversion of the second vehicle control instruction block if the second vehicle control instruction block has a disabled attribute.

To be more specific, the user can set the disabled attribute for each vehicle control instruction block. Once the disabled attribute is set, no matter the conversion is for the vehicle control instruction or the simulation operational instruction, the disabled control command block is excluded from the conversion and is skipped by default. Wherein, the user can still revoke the disabled attribute.

In the present embodiment, by setting and revoking the disabled attribute, users can observe the control effects of the vehicle control instruction blocks. If the user believes that the control effects are better when a certain one or a certain number of the vehicle control instruction blocks are disabled, he can remove the vehicle control instruction block(s) from the concatenated vehicle control instruction block. If he believes that the effects are better when the block(s) are not disabled, he may keep them.

In a preferred embodiment, the emulation method further includes:
receiving a functional parameter of a newly created vehicle control instruction block in response to a request for creating a new vehicle control instruction block, and verifying the functional parameter of the newly created vehicle control instruction block, and storing the newly created vehicle control instruction block when the verification is passed.

Here, the functional parameter is used to indicate a function of the newly created vehicle control instruction block, such as an execution action, a determination, a delay, etc. of the controlled components of the vehicle.

When verifying the newly created vehicle control instruction block, it mainly involves verifying whether there is a conflict between the newly created vehicle control instruction block and an existing vehicle control instruction block. For example, whether there is already an identical vehicle control instruction block, etc.

In the present embodiment, users can create new vehicle control instruction blocks according to their different usage habits, meeting users' usage needs.

In a preferred embodiment, the emulation method further includes:
receiving a user-selected to-be-deleted vehicle control instruction block in response to a request for deleting a vehicle control instruction block, and deleting the to-be-deleted vehicle control instruction block.

Here, before deleting, prompting the user about a function implemented by that vehicle control instruction block so as to help the user create a new vehicle control instruction block or cancel the deletion. Furthermore, after the deletion, the to-be-deleted vehicle control instruction block may be retained in a recycle bin.

In the present embodiment, users can delete vehicle control instruction blocks according to their different usage habits, meeting users' usage needs.

In a preferred embodiment, the emulation method further includes:
receiving a new name of a renamed vehicle control instruction block in response to a request for renaming a vehicle control instruction block, and checking whether the new name already exists; if it does, providing a prompt; if it doesn't, updating the name of the renamed vehicle control instruction block.

Here, in the process of renaming, the present embodiment further provides multiple languages, multiple fonts, multiple styles, multiple font sizes, and multiple font colors, and offers a preview, but the present invention is not limited thereto.

In the present embodiment, users can rename vehicle control instruction blocks according to their different usage habits, meeting users' usage needs.

In a preferred embodiment, the process of integrating and converting, by the vehicle simulation system, the functional instruction set and the inside-and-outside-vehicle environmental parameter into an instruction execution sequence, specifically includes:
verifying the functional instruction set;
converting the functional instruction set into a simulation instruction based on a preset conversion relationship when the verification is passed;
integrating the simulation instruction and the inside-and-outside-vehicle environmental parameter into the instruction execution sequence.

As an improvement of the above solutions, the process of verifying the functional instruction set, specifically includes:
checking whether each functional instruction in the functional instruction set is a valid functional instruction;
if it is, checking whether corresponding user-set parameters for each functional instruction are valid parameters;
if they are, determining that the verification is passed.

To be more specific, before converting the functional instruction set into the instruction execution sequence, it is necessary to check whether each functional instruction in the functional instruction set is a valid functional instruction; wherein, a valid functional instruction is a stored functional instruction of a current vehicle type. For example, vehicle type 1 is four-seater vehicle but the functional instructions in the functional instruction set are used for controlling front, middle and rear seats totaling six seats, in this case that functional instruction is invalid. If every functional instruction is a valid functional instruction, then further check whether corresponding user-set parameters for each the functional instruction are valid parameters, wherein a valid parameter is a pre-set parameter range. For example, the parameter range for moving a driver's seat forward and backward is 8 cm in forward and backward directions, but there is a functional instruction in the functional instruction set that controls the driver's seat to move forward by 10cm, in this case the corresponding user-set parameter for that functional instruction is invalid. If all the corresponding user-set parameters for each functional instruction are valid parameters, it is determined that the verification is passed. It's understandable that when there is an invalid functional instruction and/or an invalid parameter in the functional instruction set, it will be determined that the verification is not passed, and the user is prompted with the reason for the verification error. After passing the verification, the functional instruction set is converted into a simulation instruction based on a preset conversion relationship. Finally, the simulation instruction and the inside-and-outside-vehicle environmental parameter are integrated into the instruction execution sequence.

In a preferred embodiment, the process of converting the functional instruction set into a simulation instruction based on a preset conversion relationship, specifically includes:
extracting each functional instruction from the functional instruction set, converting each of the functional instructions into a simulation instruction fragment according to the preset conversion relationship, concatenating all the simulation instruction fragments to obtain the simulation instruction.

As an improvement of the above solutions, the preset conversion relationship includes:
extracting each functional instruction one by one according to a sequential combination order of the functional instructions within the functional instruction set;
concatenating all the simulation control instruction fragments one by one according to the sequential combination order.

Alternatively,
the preset conversion relationship includes:
extracting each functional instruction one by one according to a sequential order of the execution timings of the functional instructions within the functional instruction set;
concatenating all the simulation control instruction fragments one by one according to the sequential order of the execution timings.

It should be noted that, when combining functional instructions, the user may also set execution timings for each functional instruction. As an example, when editing the functional instruction, the user may select the default mode or the timeline mode. In the default mode, there is no need to set the execution timing for each functional instruction. All the functional instructions' execution timings are the initial timing (except for those functional instructions with a delay).In the timeline mode, it's required to set an execution timing for each functional instruction, or the execution defaults to the initial timing (except for those functional instructions with a delay).

When translating a functional instruction set, the first step is to check on an editing mode; if it is the default mode, take out each functional instruction one by one in a sequential combination order of the functional instructions within the functional instruction set, and translate each functional instruction into a corresponding simulation instruction fragment, and then sequentially concatenate all the simulation instruction fragments in the sequential combination order to obtain a complete simulation instruction. If it is the timeline mode, take out each functional instruction one by one in a sequential order of the execution timings of the functional instructions within the functional instruction set, wherein if a certain functional instruction is not set with an execution timing, prompt the user to set it, and inform that the execution will default to the initial timing if not set; then translate them into corresponding simulation instruction fragments, and then sequentially concatenate all the simulation instruction fragments in the sequential combination order to obtain the complete simulation instruction.

As an example, in the default mode, the functional instruction set is composed by sequentially concatenating a functional instruction 1, a functional instruction 2, and a functional instruction 3. Wherein an object controlled by the functional instruction 1 is a vehicle door, more specifically, "open the left top wing door" is selected, an object controlled by the functional instruction 2 is a vehicle light, more specifically, "turn on the left front vehicle light" is selected, an object controlled by the functional instruction 3 is a seat, more specifically, "move the left back seat 5cm backward" is selected. In this case, the first step is to take out the functional instruction 1, the functional instruction 2, and the functional instruction 3 one by one, and sort the three functional instructions in a sequential combination order, then generate corresponding code fragments for each functional instruction one by one according to a preset protocol, that is to say, generate respectively a code fragment 1 corresponding to opening the left top wing door, a code fragment 2 corresponding to turning on the left front vehicle light, and a code fragment 3 corresponding to moving the left back seat 5 cm backward, and finally sequentially concatenate all the code fragment 1, the code fragment 2, and the code fragment 3 to obtain the complete simulation instruction. In the timeline mode, the functional instruction set is still composed by sequentially concatenating the functional instruction 1, the functional instruction 2, and the functional instruction 3, but the execution timing of the functional instruction 1 is at 5s, the execution timing of the functional instruction 2 is at 0s, the execution timing of the functional instruction 3 is at 3s. In this case, first take out the functional instruction 2, the functional instruction 3, and the functional instruction 1 one by one, and sort them, then generate corresponding code fragments for each functional instruction one by one according to a preset protocol, that is to say, generate respectively a code fragment 2 corresponding to turning on the left front vehicle light when the execution timing is at 0s, a code fragment 3 corresponding to moving the left back seat 5 cm backward when the execution timing is at 3s, and a code fragment 1 corresponding to opening the left top wing door when the execution timing is at 5s, and finally sequentially concatenate the code fragment 2, the code fragment 3, and the code fragment 1 to obtain the complete simulation instruction.

Here, in the timeline mode, the functional instruction set may also be configured to instruct multiple vehicles to perform time-synchronized coordinated control or with-time-difference coordinated control.

As an example, the functional instruction set includes: a functional instruction 4 instructing a vehicle 1 to display a seconds countdown timer by means of projection through an ISD intellectual interaction system, and a functional instruction 5 instructing a vehicle 2 to display a marriage proposal video by means of projection through an ISD intellectual interaction system, wherein the execution time of the functional instruction 5 is after the one of the functional instruction 4 (for example, the execution timing of the functional instruction 4 is at 0s, its total execution time is 10s, then the execution timing of the functional instruction 5 is after 10s). At this moment, the user further sets the inside-and-outside-vehicle environment parameter to a nighttime environment, then the functional instruction 4, the functional instruction 5, and the nighttime environment are integrated and converted into an instruction execution sequence, following this, a vehicle model is rendered resulting in a presentation animation where two vehicles are in the nighttime environment, one projecting the seconds countdown timer and the other projecting the marriage proposal video after the countdown ends.

As a preferred solution, the preset vehicle model is a 3D vehicle model.

Here, the 3D vehicle model includes an inside-vehicle 3D model and an outside-vehicle 3D model. The inside-vehicle 3D model presents the control effects that can be observed from inside the vehicle. The outside-vehicle 3D model presents the control effects that can be observed from outside the vehicle. During the simulation emulation, the inside-vehicle 3D model and the outside-vehicle 3D model can synchronously present the control effects.

In a preferred embodiment, the method further includes:
receiving a timeline representing duration of the presentation animation;
overlaying the timeline on a preset progress bar to obtain a time progress bar of the presentation animation.

To be more specific, when the rendering result is presented in the form of an animation, the presentation animation has a duration, this presentation animation typically loops automatically but the user cannot perform actions such as time positioning. In this case, the present embodiment first receives the timeline representing the duration of the presentation animation, overlays the timeline on the preset progress bar, and marks a starting position and an ending position of the timeline on the preset progress bar, clips the time progress bar between these two positions to obtain the time progress bar of the presentation animation.

In the present embodiment, after adding the time progress bar to the presentation animation, users can drag the time progress bar to select a play or pause position.

As an improvement of the above solutions, when the editing mode is the timeline mode, the method further includes:
marking time points on the preset progress bar corresponding to the execution timings of each functional instruction.

In the present embodiment, after marking the execution timings of each functional instruction, it's convenient for users to understand the control effects of the functional instructions.

In a preferred embodiment, the method further includes:
providing a modification suggestion based on the presentation effect image and/or the presentation animation.

Here, the modification suggestion is provided based on the presentation effect image and/or the presentation animation after machine learning or deep learning.

To be more specific, the control effects of the same functional instruction set can vary in different inside-and-outside-vehicle environmental parameters. As an example, the user selects a functional instruction set under the condition that the outside-vehicle temperature is 36°C, however that functional instruction set doesn't have "turn on the air conditioner". Since 36°C makes the user feel hot, a modification suggestion of "suggest turning on the air conditioner" will be provided to the user based on that condition. As another example, the user selects a set of functional instructions for autonomous driving under the condition that he is on an urban road. However, on the urban roads, pedestrian and vehicle traffic is high during rush hours, leading to numerous unexpected situations, so autonomous driving poses significant safety hazards. In this case, a modification suggestion of "suggest disabling autonomous driving during rush hours" will be provided to the user.

In a preferred embodiment, the method further includes:
checking whether the presentation effect image and/or the presentation animation aligns with an expected outcome of the preset vehicle model executing the functional instruction set under the inside-and-outside-vehicle environmental parameter;
if it does not, pushing a simulation emulation error notification.

To be more specific, after rendering the preset vehicle model according to the instruction execution sequence, the presentation effect image and/or the presentation animation of the preset vehicle model executing the functional instruction set under the inside-and-outside-vehicle environmental parameter will be obtained. The presentation effect image and/or the presentation animation presents the states of the components of the vehicle model and the environment both inside and outside the vehicle after the execution of the instruction execution sequence. By comparing the presentation effect image and/or presentation animation with the expected rendering result indicated by the functional instruction set, it's possible to determine whether the simulation emulation result involves an error.

As an example, the expected rendering result indicated by the functional instruction set requires the left front door, right front door, left back door and right back door are open, but in the final obtained rendering result, only the left front door and the right front door are opened, this indicates that the simulation emulation result involves an error, and a simulation emulation error notification will be pushed. When the notification is pushed to the user, the user can perform a reset; when the notification is pushed to the administrator, the administrator can promptly identify the issue and restore it.

The emulation method of a simulation system for vehicle control provided by the present invention provides users with programmable functional instructions allowing users to visually concatenate the functional instructions and combine them into the functional instruction set, that functional instruction set includes execution operations for multiple controlled components of the vehicle, allowing for coordinated control of the vehicle through a single functional instruction set. Furthermore, the control effects of the coordinated control are presented through the preset vehicle model for preview, allowing users to gain advance insight into the control effects of the functional instruction set so as to make corresponding modifications or confirm the functional instruction set without the need to understand the control effects of the functional instruction set through the actual operation of the vehicle. This enhances the intelligent level of vehicle control, saves users' time and effort, and enhances the user experience. Additionally, the emulation method for a simulation system does not require direct control of the vehicle, users without a vehicle can also create the functional instruction set and observe its control effects, this is convenient for users without a vehicle to gain advance insight into the intelligent control effects of the vehicle, providing a channel to gain advance insight into the vehicle for the users without a vehicle. Meanwhile, when editing, users can select the timeline mode to set execution time for each functional instruction, enhancing the operability of vehicle control. Moreover, adding the time progress bar to the presentation animation and marking the execution timings of the functional instructions on the time progress bar makes it convenient for user to locate the presentation position and accurately understand the time sequence of the execution of the functional instructions.

It should be understood that all or part of the processes in the emulation method for a vehicle simulation system described herein can also be executed by instructing relevant hardware through computer programs. The computer program may be stored in a computer-readable storage medium, and when the computer program is executed by the processor, the steps of the above-mentioned emulation method for a vehicle simulation system can be implemented. The computer program includes a computer program code. The computer program code may be in a form of source code, object code, an executable file or in some intermediate forms. The computer-readable medium may include any entity or apparatus capable of carrying the computer program code, a recording medium, a USB flash drive, a removable hard disk, a magnetic disk, an optical disk, a computer memory, a Read-Only Memory (ROM, Read-Only Memory), a Random Access Memory (RAM, Random Access Memory), an electrical carrier signal, a telecommunication signal, a software distribution medium, and so on. It should be noted that the content included in the computer-readable medium may be added or reduced properly according to requirements of legal and patent practices of certain jurisdictions. For example, in some jurisdictions, according to their requirements of legal and patent practices, the computer-readable media does not include electrical carrier signals or telecommunications signals.

Another embodiment of the present invention provides an emulation device for a vehicle simulation system. For details, please refer to FIG. 2. FIG. 2 illustrates a schematic diagram of a structure of an emulation apparatus for a vehicle simulation system according to one of the embodiments of the present invention. The apparatus includes:
a receiving module 11, configured to receive an inside-and-outside-vehicle environmental parameter and a functional instruction set obtained through a user's operation on a vehicle control instruction block;
a converting module 12, configured to integrate and convert the functional instruction set and the inside-and-outside-vehicle environmental parameter into an instruction execution sequence;
a rendering module 13, configured to render a preset vehicle model according to the instruction execution sequence to obtain a presentation effect image and/or a presentation animation of the preset vehicle model executing the functional instruction set under the inside-and-outside-vehicle environmental parameter.

Yet another embodiment of the present invention provides a vehicle server, including:
a memory, configured to store a computer program;
a processor, configured to execute the computer program;
wherein, when executing the computer program, the processor implements the emulation method for a vehicle simulation system as described above.

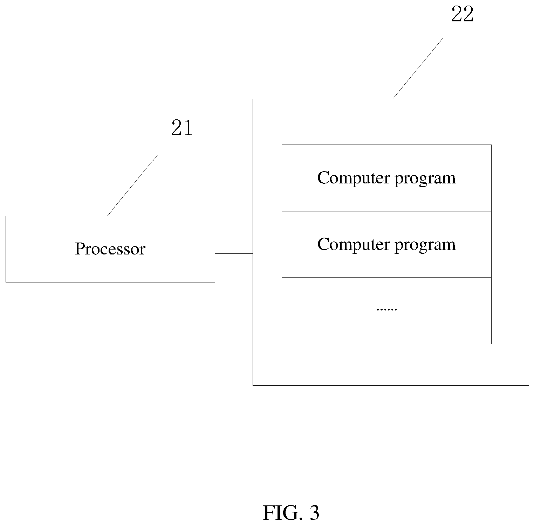

Refer to FIG. 3, which is a structural block diagram of a terminal device provided in an embodiment of the present invention. The terminal device 20 provided in the embodiments of the present invention includes a processor 21, a memory 22 and a computer program stored in the memory 22 and configured to be executed by the processor 21; when executing the computer program, the processor 21 implements the steps of the emulation method for a vehicle simulation system described in the above embodiments, such as the steps S1 to S3 shown in FIG. 1; alternatively, when executing the computer program, the processor 21 implements the functions of the respective modules described in the above apparatus embodiments, such as the receiving module 11.

As an example, the computer program may be divided into one or more modules, the one or more modules are stored in the memory 22 and executed by the processor 21 to achieve the present invention. The one or more modules may be a series of computer program instruction segments capable of performing specific functions, and the instruction segments are configured to describe the execution process of the computer program on the terminal device 20. For example, the computer program may be divided into a receiving module 11, a converting module 12, a rendering module 13. The functions of each module are as follows:
a receiving module 11, configured to receive an inside-and-outside-vehicle environmental parameter and a functional instruction set obtained through a user's operation on a vehicle control instruction block;
a converting module 12, configured to integrate and convert the functional instruction set and the inside-and-outside-vehicle environmental parameter into an instruction execution sequence;
a rendering module 13, configured to render a preset vehicle model according to the instruction execution sequence to obtain a presentation effect image and/or a presentation animation of the preset vehicle model executing the functional instruction set under the inside-and-outside-vehicle environmental parameter.

The terminal device 20 may include, but is not limited to, the processor 21, the memory 22. Those skilled in the art can understand that the schematic diagram is merely an example of the terminal device and does not limit the terminal device 20. More or fewer components than shown in the diagram or a combination of certain components, or different components may be included. For example, the terminal device 20 may also include an input/output device, a network access device, a bus, and so on.

The processor 21 may be a Central Processing Unit (CPU, Central Processing Unit), or it may be another general-purpose processor, a Digital Signal Processor (DSP, Digital Signal Processor), an Application Specific Integrated Circuit (ASIC, Application Specific Integrated Circuit), a Field-Programmable Gate Array (FPGA, Field-Programmable Gate Array), or other programmable logic devices, discrete gates or transistor logic devices, discrete hardware components, and the like. The general-purpose processor may be a microprocessor or the processor may be any conventional processor, and so on. The processor 21 is the control center of the terminal device 20 and connects various parts of the terminal device 20 using various interfaces and lines.

The memory 22 is configured to store the computer program and/or modules. The processor 21 runs or executes the computer program and/or modules stored in the memory 22, and calls data stored in the memory 22 to implement various functions of the terminal device 20. The memory 22 mainly includes a program storage area and a data storage area. The program storage area may store an operating system, an application program required by at least one function (such as a sound play function or an image play function), and the like. The data storage area may store data (such as audio data or an address book) that is created based on use of the mobile phone, and the like. In addition, the memory 22 may include a high-speed random access memory, and may further include a nonvolatile memory, for example, hard disk, memory, plug-in hard drive, Smart Media Card (SMC, Smart Media Card), Secure Digital (SD, Secure Digital) card, flash card, at least one magnetic disk storage device, a flash storage device, or another volatile solid-state storage device.

Here, if the modules integrated in the terminal device 20 are implemented as software functional units and sold or used as independent products, they may be stored on a computer-readable storage medium. Based on this understanding, all or part of the processes of the methods implemented in the above embodiments of the present invention may also be achieved through computer programs instructing the relevant hardware. The computer program may be stored in a computer-readable storage medium, and when the computer program is executed by the processor, the steps of the various method embodiments described above can be implemented. The computer program includes a computer program code. The computer program code may be in a form of source code, object code, an executable file or in some intermediate forms. The computer-readable medium may include any entity or apparatus capable of carrying the computer program code, a recording medium, a USB flash drive, a removable hard disk, a magnetic disk, an optical disk, a computer memory, a Read-Only Memory (ROM, Read-Only Memory), a Random Access Memory (RAM, Random Access Memory), an electrical carrier signal, a telecommunication signal, a software distribution medium, and so on.

Those skilled in the art should understand that all or part of the processes of the methods implemented in the above embodiments may be achieved through computer programs instructing the relevant hardware. The program may be stored in a computer-readable storage medium, and when the program is executed by the processor, the processes of various method embodiments described above can be implemented. The storage medium may be a magnetic disk, a CD, a Read-Only Memory (ROM, Read-Only Memory), or a Random Access Memory (RAM, Random Access Memory), and so on.

Furthermore, an embodiment of the present invention provides a vehicle, the vehicle includes the terminal device as described above.

In the embodiments of the present invention, the emulation method for a vehicle simulation system is executed by the vehicle simulation system. The vehicle simulation system provides feedback in the form of a presentation effect image and/or a presentation animation to show the corresponding result generated by the user operation, making it convenient for users to intuitively grasp the simulation result. Preferably, during the simulation, the vehicle-mounted control system can also convert the user operation into a real vehicle control instruction to control corresponding actions of the vehicle. For example, if the user issues an instruction through the simulation system to open a front passenger window of an electric vehicle within a preset time interval, the vehicle simulation system will simulate and display that instruction using a presentation effect image and/or a presentation animation. Meanwhile, the real electric vehicle will also synchronously execute the instruction to open the front passenger window within the preset time interval, namely achieving synchronized execution of both simulation display and real control.

Furthermore, to achieve the above-mentioned effects, an embodiment of the present invention provides a vehicle control system, including a vehicle simulation system and a vehicle-mounted control system; the vehicle simulation system is configured to perform a corresponding emulation function, the vehicle-mounted control system is configured to control the vehicle's controlled component corresponding to the functional instruction set to execute synchronously the vehicle control instruction corresponding to the functional instruction set while the vehicle simulation system obtains the presentation effect image and/or the presentation animation.

To be more specific, the vehicle simulation system includes a first operating terminal. The user may operate a building-block-style block on the first operating terminal, constructing a functional instruction set on the first operating terminal through actions such as dragging, stretching, concatenating, and so on. After obtaining the above functional instruction set, the vehicle simulation system performs the above-mentioned steps S1 to S3 to finally obtain a presentation effect image and/or a presentation animation. Meanwhile, the on-board control system receives the functional instruction set. At this point, the functional instruction set represents the control instruction for the controlled components of the vehicle (such as the above-mentioned front passenger window), but as it is still composed of building-block-style vehicle control instruction blocks, it cannot be recognized by the vehicle. After the functional instruction set is converted into instructions that are recognizable to the vehicle, the controlled component of the vehicle executes the instructions synchronously. In other words, the front passenger window is opened within the preset time interval, thereby achieving synchronized execution of software simulation and real control.

Preferably, the first operating terminal is located on a vehicle display, more specifically, on a central console of the vehicle.

Certainly, with the continuous advancement of technology, to overcome the limitations of the position of the vehicle's central console and to enable users' mobile operations or remote operations, the vehicle control system in the present embodiment further includes a user terminal system. The user terminal system has a second operating terminal for the user to operate the vehicle control instruction block, and the user terminal system is configured to send the operation result to the vehicle simulation system and the vehicle-mounted control system, respectively; in other words, when the user operates on the building-block-style blocks by actions such as dragging, stretching, concatenating, and so on, the operation interface may be on the vehicle's central console, or on a mobile human-machine interaction device such as a mobile phone, a laptop, or a tablet, and the like. Users can control the vehicle anytime, anywhere through portable devices, without being dependent on the vehicle's central console, thus enhancing the user experience

Likewise, after the user completes his operation on the second operating terminal of the user terminal system, the corresponding presentation effect image and/or presentation animation can be displayed on the vehicle's central console (i.e., the first operating terminal) or be displayed on the user terminal (i.e., the second operating terminal). Details are not described herein.

Correspondingly, the embodiments of the present invention provide a computer-readable storage medium, the computer-readable storage medium includes a stored computer program, wherein when the computer program runs, a device in which the computer-readable storage medium is located is controlled to execute steps of the emulation method for a vehicle simulation system described in an above embodiment, such as the steps S1∼S3 shown in FIG. 1.

Compared with the prior art, the beneficial effects of the embodiments of the present invention include at least one of the following points.
(1) Users can visually concatenate the functional instructions, combine them into a functional instruction set, this functional instruction set includes execution operations for multiple controlled components of the vehicle, allowing for coordinated control of the vehicle through a single functional instruction set. Furthermore, the control effects of the coordinated control are presented through a preset vehicle model for preview, allowing users to gain advance insight into the control effects of the functional instruction set so as to make corresponding modifications or confirm the functional instruction set without the need to understand the control effects of the functional instruction set through the actual operation of the vehicle. This enhances the intelligent level of vehicle control, saves users' time and effort, and enhances the user experience. Additionally, the emulation method for a vehicle simulation system does not require direct control of the vehicle, users without a vehicle can also create the functional instruction set and observe its control effects, this is convenient for users without a vehicle to gain advance insight into the intelligent control effects of the vehicle, providing a channel to gain advance insight into the vehicle for the users without a vehicle.
(2) When users need to download a software package, the version options of the software package are provided, and after the user selects the target version, the target software package corresponding to that target version is downloaded. This improves the flexibility of version selection during software package download and is convenient for the user to select the version of software package to be downloaded, allows the user to select the version of the software package based on his usage habits, thereby enhancing the user's driving experience.
(3) The embodiments of the present invention receive user's operation information concerning the vehicle control command blocks. When there is an anomaly in the operation information, check its anomaly level. When the anomaly level meets the anomaly level condition, send the abnormal operation information directly to the abnormal operation information processing terminal for developers to analyze. Automatically classify the abnormal operation information, distinguish the urgency of the abnormal operation information, and send the operation information that meets the preset anomaly level condition directly to the administrator's terminal device. This facilitates issue identification and resolution for administrators, shortening the time period for processing anomaly-related logs generated by the abnormal operation information, reducing the time and effort required for log processing, enhancing the efficiency of server processing.
(4) Provide users with vehicle control instruction blocks, allowing users to visually program the vehicle control instructions, reducing the entry barrier for users to control a vehicle through programming, decreasing the complexity of writing vehicle control instructions for users, and enhancing the efficiency of user editing of vehicle control instructions. In addition, the vehicle control instruction blocks have the concatenatable attribute, which means they can be concatenated into a concatenated vehicle control instruction block, achieving coordinated control of the controlled components of the vehicle. Moreover, the concatenated vehicle control instruction block is convenient for user to understand and modify as a whole, further enhancing the efficiency of user editing of vehicle control instructions. In addition, the vehicle control instruction blocks also have the splittable attribute, which means the vehicle control instruction block can be splitted, making it convenient to modify the vehicle control instruction block, further enhancing the efficiency of user editing of vehicle control instructions.

The above embodiments only represent several implementations of the present invention, their description is more specific and detailed, but they should not be understood as limiting the scope of the present invention. It should be noted that for those skilled in the art, various modifications and improvements can be made without departing from the concept of the invention, these modifications and improvements should be included within the scope of the present invention. Therefore, the scope of protection of the present invention is defined by the attached claims.

## Claims

1. An emulation method for a vehicle simulation system, wherein the method comprises:
receiving, by the vehicle simulation system, an inside-and-outside-vehicle environmental parameter and a functional instruction set obtained through a user's operation on a vehicle control instruction block;
integrating and converting, by the vehicle simulation system, the functional instruction set and the inside-and-outside-vehicle environmental parameter into an instruction execution sequence;
rendering, by the vehicle simulation system, a preset vehicle model according to the instruction execution sequence to obtain a presentation effect image and/or a presentation animation of the preset vehicle model executing the functional instruction set under the inside-and-outside-vehicle environmental parameter.

2. The emulation method for a vehicle simulation system as claimed in claim 1, wherein before the process of receiving, by the vehicle simulation system, an inside-and-outside-vehicle environmental parameter and a functional instruction set obtained through a user's operation on a vehicle control instruction block, the method further comprises:
downloading, by the vehicle simulation system, a software package of the vehicle control instruction block based on OTA technology;
processing, by the vehicle simulation system, the software package of the vehicle control instruction block to obtain the vehicle control instruction block for the user to operate.

3. The emulation method for a vehicle simulation system as claimed in claim 2, wherein the process of downloading, by the vehicle simulation system, a software package of the vehicle control instruction block based on OTA technology, specifically comprises:
sending, by the vehicle simulation system, a download request for the software package of the vehicle control instruction block to a vehicle server;
receiving, by the vehicle simulation system, version options for the software package of the vehicle control instruction block sent by the vehicle server according to the download request;
sending, by the vehicle simulation system, version information of a target version selected from the version options by the user to the vehicle server;
receiving, by the vehicle simulation system, a download address of a target software package of the vehicle control instruction block sent by the vehicle server according to the version information of the target version;
downloading, by the vehicle simulation system, the target software package of the vehicle control instruction block according to the download address based on OTA technology.

4. The emulation method for a vehicle simulation system as claimed in claim 3, wherein the download request comprises a device identifier of the vehicle, current version information of the software package of the vehicle control instruction block, and version authentication information corresponding to the current version information;
wherein the device identifier, the current version information, and the version authentication information corresponding to the current version information are used for the vehicle server to authenticate the download request.

5. The emulation method for a vehicle simulation system as claimed in claim 4, wherein after the process of downloading, by the vehicle simulation system, the target software package of the vehicle control instruction block according to the download address, the method further comprises:
loading, by the vehicle simulation system, the target software package of the vehicle control instruction block, updating the current version information to the version information of the target software package of the vehicle control instruction block, and updating the version authentication information corresponding to the current version information to the version authentication information corresponding to the target software package of the vehicle control instruction block.

6. The emulation method for a vehicle simulation system as claimed in claim 3, wherein in a case where a plurality of the download addresses are provided, the process of downloading, by the vehicle simulation system, the target software package of the vehicle control instruction block according to the download address, specifically comprises:
receiving, by the vehicle simulation system, a download speed of the target software package of the vehicle control instruction block at a current selected download address;
switching to a different download address to download the target software package of the vehicle control instruction block when there is an anomaly in the download speed.

7. The emulation method for a vehicle simulation system as claimed in claim 3, wherein the process of downloading, by the vehicle simulation system, the target software package of the vehicle control instruction block according to the download address, specifically comprises:
downloading, by the vehicle simulation system, all program blocks of the target software package of the vehicle control instruction block according to the download address and a pre-set download order of the program blocks of the target software package of the vehicle control instruction block.

8. The emulation method for a vehicle simulation system as claimed in claim 7, wherein the process of downloading, by the vehicle simulation system, all program blocks of the target software package of the vehicle control instruction block according to the download address and a pre-set download order of the program blocks of the target software package of the vehicle control instruction block, specifically comprises:
downloading, by the vehicle simulation system, the program block of the target software package of the vehicle control instruction block according to the download address and the pre-set download order of the program blocks of target software package of the vehicle control instruction block and receiving the download speed of the program block;
choosing a next program block in the download order for downloading when there is an anomaly in the download speed until all the program blocks of the target software package of the vehicle control instruction block are downloaded.

9. The emulation method for a vehicle simulation system as claimed in claim 3, wherein the process of downloading, by the vehicle simulation system, the target software package of the vehicle control instruction block according to the download address, specifically comprises:
verifying, by the vehicle simulation system, validity of the download address;
downloading the target software package of the vehicle control instruction block when the download address is valid.

10. The emulation method for a vehicle simulation system as claimed in claim 9, wherein the target software package of the vehicle control instruction block is encrypted, in this case after the process of downloading, by the vehicle simulation system, the target software package of the vehicle control instruction block, the method further comprises:
decrypting, by the vehicle simulation system, the target software package of the vehicle control instruction block to obtain a decrypted target software package of the vehicle control instruction block;
verifying, by the vehicle simulation system, validity of the decrypted target software package of the vehicle control instruction block;
loading the decrypted target software package of the vehicle control instruction block when the decrypted target software package of the vehicle control instruction block is valid.

11. The emulation method for a vehicle simulation system as claimed in claim 1, wherein the method further comprises:
receiving, by the vehicle server, the user's operation information for the vehicle simulation system;
storing, by the vehicle server, the operation information.

12. The emulation method for a vehicle simulation system as claimed in claim 11, wherein the process of storing, by the vehicle server, the operation information, specifically comprises:
checking, by the vehicle server, whether there is an anomaly in the operation information;
storing, by the vehicle server, the operation information on a disk as an abnormal operation information if there is an anomaly in the operation information;
storing, by the vehicle server, the operation information on the disk as a normal operation information if there is no anomaly in the operation information and recording a storing time.

13. The emulation method for a vehicle simulation system as claimed in claim 12, wherein after the process of storing, by the vehicle server, the operation information on a disk as an abnormal operation information, the method further comprises:
checking, by the vehicle server, an anomaly level of the abnormal operation information;
sending, by the vehicle server, the abnormal operation information to an abnormal operation information processing terminal when the anomaly level meets a preset anomaly level condition.

14. The emulation method for a vehicle simulation system as claimed in claim 13, wherein the process of checking, by the vehicle server, whether there is an anomaly in the operation information, specifically comprises:
checking, by the vehicle server, whether the vehicle control instruction block is a registered valid vehicle control instruction block;
determining, by the vehicle server, that there is an anomaly in the operation information if the vehicle control instruction block is not a valid vehicle control instruction block;
checking, by the vehicle server, whether a version of the vehicle control instruction block is the current version if the vehicle control instruction block is a valid vehicle control instruction block;
determining, by the vehicle server, that there is an anomaly in the operation information if the version is not the current version;
checking, by the vehicle server, whether a parameter configured in the vehicle control instruction block exceeds a parameter threshold range if the version is the current version;
determining, by the vehicle server, that there is an anomaly in the operation information if the parameter exceeds the parameter threshold range;
determining, by the vehicle server, that there is no anomaly in the operation information if the parameter doesn't exceed the parameter threshold range;

15. The emulation method for a vehicle simulation system as claimed in claim 12, wherein the process of storing, by the vehicle server, the operation information on the disk as a normal operation information if there is no anomaly in the operation information and recording a storing time, specifically comprises:
compressing, by the vehicle server, the operation information through a preset compression algorithm if there is no anomaly in the operation information;
storing, by the vehicle server, the compressed operation information on the disk as a normal operation information and recording the storing time.

16. The emulation method for a vehicle simulation system as claimed in any one of claim 12 and claim 15, wherein the method further comprises:
checking, by the vehicle server, whether a usage rate of the disk is greater than a usage rate threshold;
deleting, by the vehicle server, the normal operation information according to the storing time if the usage rate is greater than the usage rate threshold.

17. The emulation method for a vehicle simulation system as claimed in claim 13, wherein the anomaly level dynamically increases or decreases according to a frequency of occurrence of a type of the abnormal operation information.

18. The emulation method for a vehicle simulation system as claimed in claim 13, wherein the process of sending, by the vehicle server, the abnormal operation information to an abnormal operation information processing terminal, specifically comprises:
encrypting, by the vehicle server, the abnormal operation information and setting a permission level, and then sending the abnormal operation information to the abnormal operation information processing terminal.

19. The emulation method for a vehicle simulation system as claimed in claim 1, wherein the process of receiving, by the vehicle simulation system, a functional instruction set obtained through a user's operation on a vehicle control instruction block, specifically comprises:
checking, by the vehicle simulation system, in response to an operational instruction of the user, whether the vehicle control instruction block meets a predefined operational condition of vehicle control instruction block; the operational condition of vehicle control instruction block comprises: the vehicle control instruction block has a concatenatable attribute or a splittable attribute; the operational instruction comprises: a concatenating instruction or a splitting instruction;
performing a control operation of the vehicle control instruction block corresponding to the operational instruction to obtain the functional instruction set if the vehicle control instruction block meets the operational condition; the control operation comprises accordingly: concatenating or splitting the vehicle control instruction block that meets the operational condition of vehicle control instruction block.

20. The emulation method for a vehicle simulation system as claimed in claim 19, wherein in a case where the operational instruction comprises the concatenating instruction, and a first vehicle control instruction block and a second vehicle control instruction block have the concatenatable attribute;
the process of performing a control operation of the vehicle control instruction block corresponding to the operational instruction to obtain the functional instruction set comprises:
providing a ready-to-concatenate prompt when the first vehicle control instruction block and the second vehicle control instruction block meet the operational condition of vehicle control instruction block; and
concatenating the first vehicle control instruction block and the second vehicle control instruction block into a third vehicle control instruction block when a state of the first vehicle control instruction block is changed from a selected state to an unselected state.

21. The emulation method for a vehicle simulation system as claimed in claim 20, wherein the method further comprises:
controlling the second vehicle control instruction block to move along with the first vehicle control instruction block when the first vehicle control instruction block within the third vehicle control instruction block is selected to move; wherein, in the third vehicle control instruction block, the first vehicle control instruction block is a front vehicle control instruction block, the second vehicle control instruction block is a back vehicle control instruction block.

22. The emulation method for a vehicle simulation system as claimed in claim 21, wherein the method further comprises:
splitting the third vehicle control instruction block into the first vehicle control instruction block and the second vehicle control instruction block when the second vehicle control instruction block within the third vehicle control instruction block is selected to move, and controlling the second vehicle control instruction block to move separately.

23. The emulation method for a vehicle simulation system as claimed in claim 20, wherein the method further comprises:
receiving, by the vehicle simulation system, a first execution time point of the first vehicle control instruction block and a second execution time point of the second vehicle control instruction block within the third vehicle control instruction block; converting the first vehicle control instruction block into a first vehicle control instruction fragment and converting the second vehicle control instruction block into a second vehicle control instruction fragment, concatenating the first vehicle control instruction fragment and the second vehicle control instruction fragment in a sequential order based on a sequential execution order of the first execution time point and the second execution time point to obtain the functional instruction set.

24. The emulation method for a vehicle simulation system as claimed in claim 20, wherein the method further comprises:
receiving, by the vehicle simulation system, a first execution time point of the first vehicle control instruction block and a second execution time point of the second vehicle control instruction block within the third vehicle control instruction block; converting the first vehicle control instruction block into a first vehicle control instruction fragment and converting the second vehicle control instruction block into a second vehicle control instruction fragment, concatenating the first vehicle control instruction fragment and the second vehicle control instruction fragment in a reverse order based on a sequential execution order of the first execution time point and the second execution time point to obtain the functional instruction set.

25. The emulation method for a vehicle simulation system as claimed in claim 20, wherein the method further comprises:
receiving, by the vehicle simulation system, the first vehicle control instruction block and the second vehicle control instruction block within the third vehicle control instruction block, converting the first vehicle control instruction block into a first vehicle control instruction fragment and converting the second vehicle control instruction block into a second vehicle control instruction fragment, concatenating the first vehicle control instruction fragment and the second vehicle control instruction fragment in a random order to obtain the functional instruction set.

26. The emulation method for a vehicle simulation system as claimed in any one of claims 23-25, wherein the method further comprises:
during converting the third vehicle control instruction block, skipping, by the vehicle simulation system, the conversion of the first vehicle control instruction block if the first vehicle control instruction block has a disabled attribute, skipping the conversion of the second vehicle control instruction block if the second vehicle control instruction block has a disabled attribute.

27. The emulation method for a vehicle simulation system as claimed in claim 1, wherein the process of integrating and converting, by the vehicle simulation system, the functional instruction set and the inside-and-outside-vehicle environmental parameter into an instruction execution sequence, specifically comprises:
verifying the functional instruction set;
converting the functional instruction set into a simulation instruction based on a preset conversion relationship when the verification is passed;
integrating the simulation instruction and the inside-and-outside-vehicle environmental parameter into the instruction execution sequence.

28. The emulation method for a vehicle simulation system as claimed in claim 27, wherein the process of verifying the functional instruction set, specifically comprises:
checking whether each functional instruction in the functional instruction set is a valid functional instruction;
if it is, checking whether corresponding user-set parameters for each functional instruction are valid parameters;
if they are, determining that the verification is passed.

29. The emulation method for a vehicle simulation system as claimed in claim 27, wherein the process of converting the functional instruction set into a simulation instruction based on a preset conversion relationship, specifically comprises:
extracting each functional instruction from the functional instruction set, converting each of the functional instruction into a simulation instruction fragment according to the preset conversion relationship, concatenating all the simulation instruction fragments to obtain the simulation instruction.

30. The emulation method for a vehicle simulation system as claimed in claim 29, wherein the preset conversion relationship comprises:
extracting each functional instruction one by one according to a sequential combination order of the functional instructions within the functional instruction set;
concatenating all the simulation control instruction fragments one by one according to the sequential combination order.

31. The emulation method for a vehicle simulation system as claimed in claim 29, wherein the preset conversion relationship comprises:
extracting each functional instruction one by one according to a sequential order of the execution timings of the functional instructions within the functional instruction set;
concatenating all the simulation control instruction fragments one by one according to the sequential order of the execution timings.

32. The emulation method for a vehicle simulation system as claimed in claim 1, wherein the preset vehicle model is a 3D vehicle model.

33. The emulation method for a vehicle simulation system as claimed in claim 1, wherein the method further comprises:
receiving a timeline representing duration of the presentation animation;
overlaying the timeline on a preset progress bar to obtain a time progress bar of the presentation animation.

34. The emulation method for a vehicle simulation system as claimed in claim 1, wherein the method further comprises:
providing a modification suggestion based on the presentation effect image and/or the presentation animation.

35. The emulation method for a vehicle simulation system as claimed in claim 1, wherein the method further comprises:
checking whether the presentation effect image and/or the presentation animation aligns with an expected outcome of the preset vehicle model executing the functional instruction set under the inside-and-outside-vehicle environmental parameter;
if it does not, pushing a simulation emulation error notification.

36. An emulation apparatus for a vehicle simulation system, wherein the apparatus comprises:
a receiving module, configured to receive an inside-and-outside-vehicle environmental parameter and a functional instruction set obtained through a user's operation on a vehicle control instruction block;
a converting module, configured to integrate and convert the functional instruction set and the inside-and-outside-vehicle environmental parameter into an instruction execution sequence;
a rendering module, configured to render a preset vehicle model according to the instruction execution sequence to obtain a presentation effect image and/or a presentation animation of the preset vehicle model executing the functional instruction set under the inside-and-outside-vehicle environmental parameter.

37. A vehicle server, wherein the vehicle server comprises:
a memory, configured to store a computer program;
a processor, configured to execute the computer program;
wherein when executing the computer program, the processor implements the emulation method for a vehicle simulation system as claimed in any one of claims 3-18.

38. A terminal device, comprising a memory, a processor, and a computer program stored in the memory and executable on the processor; wherein when executing the computer program, the processor implements the emulation method for a vehicle simulation system as claimed in any one of claims 1-35.

39. A vehicle, wherein the vehicle comprises the terminal device as claimed in claim 38.

40. A vehicle control system, wherein the vehicle control system comprises: a vehicle simulation system and a vehicle-mounted control system;
the vehicle simulation system is configured to perform the emulation method for a vehicle simulation system as claimed in any one of claims 1-35;
the vehicle-mounted control system is configured to control a vehicle's controlled component corresponding to the functional instruction set to execute synchronously a vehicle control instruction corresponding to the functional instruction set while the vehicle simulation system obtains the presentation effect image and/or presentation animation.

41. The vehicle control system as claimed in claim 40, wherein the vehicle simulation system has a first operating terminal;
the process of receiving, by the vehicle simulation system, a functional instruction set obtained through a user's operation on a vehicle control instruction block, specifically comprises:
operating, by the user, the vehicle control instruction block through the first operating terminal;
sending, by the first operating terminal, an operation result to the vehicle simulation system enabling the vehicle simulation system to obtain the functional instruction set.

42. The vehicle control system as claimed in claim 41, wherein the first operating terminal is a central console of the vehicle.

43. The vehicle control system as claimed in claim 40, wherein the vehicle control system further comprises a user terminal system;
the user terminal system has a second operating terminal for the user to operate the vehicle control instruction block, and the user terminal system is configured to send the operation result to the vehicle simulation system and the vehicle-mounted control system, respectively.

44. The vehicle control system as claimed in claim 43, wherein the second operating terminal is a mobile human-machine interaction device, and the mobile human-machine interaction device is a mobile phone, a laptop, or a tablet.

45. A computer-readable storage medium, wherein the computer-readable storage medium stores a computer program, wherein when the computer program runs, a device in which the computer-readable storage medium is located is controlled to perform the emulation method for a vehicle simulation system as claimed in any one of claims 1-35.
